# EUROPEAN PATENT APPLICATION

(11) **EP 4 697 686 A1**
(43) Date of publication of application: **18.02.2026**
(21) Application number: 24896559.2
(22) Date of filing: 27.11.2024
(51) Int. Cl.: H04M 1/02

(54) **FOLDING MECHANISM AND ELECTRONIC DEVICE**

(30) Priority: 29.11.2023 CN 202311626762
(71) Applicant: Huawei Technologies Co., Ltd., Shenzhen, Guangdong 518129 (CN)
(72) Inventor: WU, Weifeng, Shenzhen, Guangdong 518129 (CN); LIU, Yong, Shenzhen, Guangdong 518129 (CN); ZHONG, Ding, Shenzhen, Guangdong 518129 (CN); ZHAN, Qiang, Shenzhen, Guangdong 518129 (CN); TIAN, Haiqiang, Shenzhen, Guangdong 518129 (CN); HUA, Leilei, Shenzhen, Guangdong 518129 (CN)
(74) Representative: Maiwald GmbH
(86) International application number: PCT/CN2024/134788
(87) International publication number: WO 2025/113473

(57) **Abstract**

This application provides a folding mechanism and an electronic device. The folding mechanism includes a main shaft, a first fastening bracket, a second fastening bracket, a first rotating member, a second rotating member, a first support plate, a second support plate, and a first connecting arm. The first rotating member movably connects the main shaft to the first fastening bracket, and the second rotating member movably connects the main shaft to the second fastening bracket. The first support plate movably connects the first fastening bracket to the first rotating member, and the second support plate movably connects the second fastening bracket to the second rotating member. The first connecting arm movably connects the first fastening bracket to the main shaft, the first connecting arm has a first fitting surface, the first support plate has a second fitting surface, and when the folding mechanism is in an unfolded state, the first fitting surface of the first connecting arm is in interference fit with the second fitting surface of the first support plate, so that an angle between the first support plate and the main shaft is controlled through acting force between the first fitting surface and the second fitting surface, and the angle between the first support plate and the main shaft is equal to 180° as much as possible.

## Description

This application claims priority to Chinese Patent Application No. 202311626762.8, filed with the China National Intellectual Property Administration on November 29, 2023 and entitled "FOLDING MECHANISM AND ELECTRONIC DEVICE", which is incorporated herein by reference in its entirety.

### TECHNICAL FIELD

This application relates to the field of foldable electronic product technologies, and in particular, to a folding mechanism and an electronic device.

### BACKGROUND

A foldable mobile phone is increasingly popular among users because of features such as a large display area in an unfolded state and a small size in a folded state. An angle in the unfolded state of the foldable mobile phone is crucial for delicacy of the entire mobile phone. Therefore, it is particularly important to dispose a folding mechanism that can accurately adjust the angle in the unfolded state.

### SUMMARY

This application provides a folding mechanism that can accurately adjust an angle in an unfolded state, and an electronic device.

According to a first aspect, this application provides a folding mechanism. The folding mechanism includes a main shaft, a first fastening bracket, a second fastening bracket, a first rotating member, a second rotating member, a first support plate, a second support plate, and a first connecting arm. The main shaft is located between the first fastening bracket and the second fastening bracket. The first rotating member movably connects the main shaft to the first fastening bracket, and the second rotating member movably connects the main shaft to the second fastening bracket.

The first support plate movably connects the first fastening bracket to the first rotating member, the second support plate movably connects the second fastening bracket to the second rotating member, and when the folding mechanism is in an unfolded state, the first support plate and the second support plate jointly form a support surface, or when the folding mechanism is in a folded state, the first support plate and the second support plate are disposed opposite to each other, and enclose a screen-accommodating space with the main shaft.

The first connecting arm movably connects the first fastening bracket to the main shaft, the first connecting arm has a first fitting surface, the first support plate has a second fitting surface, and when the folding mechanism is in the unfolded state, the first fitting surface of the first connecting arm is in interference fit with the second fitting surface of the first support plate.

It may be understood that the first fitting surface of the first connecting arm is disposed to be in interference fit with the second fitting surface of the first support plate, so that the first support plate generates acting force in a movement direction. In this way, because there is a magnitude of interference set between the first fitting surface of the first connecting arm and the second fitting surface of the first support plate, acting force can be generated between the first fitting surface of the first connecting arm and the second fitting surface of the first support plate. Therefore, the acting force is used to control an angle between the first support plate and the main shaft, that is, control a form of the first support plate in the unfolded state of the folding mechanism. For example, the acting force between the first fitting surface of the first connecting arm and the second fitting surface of the first support plate may cause the angle between the first support plate and the main shaft to be equal to 180° as much as possible, to ensure that a flexible display is completely unfolded when the folding mechanism is used in an electronic device. In this way, the flexible display has good appearance consistency, to meet user experience. Therefore, this application provides the folding mechanism that can accurately adjust the angle in the unfolded state.

It may be understood that, for different folding mechanisms, angles between first support plates and main shafts deviate from 180° by different amplitudes when the folding mechanisms are in an unfolded state. In this case, the angle between the first support plate and the main shaft can be adjusted to different degrees by adjusting the magnitude of the interference between the first fitting surface of the first connecting arm and the second fitting surface of the first support plate to different degrees, to better control the form of the first support plate in the unfolded state of the folding mechanism. For example, for some folding mechanisms, when the folding mechanism is in the unfolded state, the angle between the first support plate and the main shaft is 190° that deviates from 180° by a large amplitude. In this case, the magnitude of the interference between the first fitting surface of the first connecting arm and the second fitting surface of the first support plate can be greatly increased, to adjust the angle between the first support plate and the main shaft to a large degree in the unfolded state of the folding mechanism, so that the angle between the first support plate and the main shaft can be 180°. For some folding mechanisms, when the folding mechanism is in the unfolded state, the angle between the first support plate and the main shaft is 185° that deviates from 180° by a small amplitude. In this case, the magnitude of the interference between the first fitting surface of the first connecting arm and the second fitting surface of the first support plate can be slightly increased, to slightly adjust the angle between the first support plate and the main shaft, so that the angle between the first support plate and the main shaft can be 180°.

In a possible implementation, the first connecting arm has a third fitting surface, and the first support plate has a fourth fitting surface. When the folding mechanism is in the folded state, the third fitting surface of the first connecting arm is in interference fit with the fourth fitting surface of the first support plate.

It may be understood that the third fitting surface of the first connecting arm may be in interference fit with the fourth fitting surface of the first support plate. In this way, because there is a magnitude of interference set between the third fitting surface of the first connecting arm and the fourth fitting surface of the first support plate, acting force F can be generated between the third fitting surface of the first connecting arm and the fourth fitting surface of the first support plate, and the acting force F can open the first support plate. In this case, the screen-accommodating space enclosed by the first support plate, the main shaft, and the second support plate can be increased. This helps improve reliability of the flexible display.

It may be understood that, when the folding mechanism is in the folded state, an opening angle of the first support plate can be adjusted to different degrees by adjusting the magnitude of the interference between the third fitting surface of the first connecting arm and the fourth fitting surface of the first support plate to different degrees, to better control a size of the screen-accommodating space.

In a possible implementation, the first support plate includes a first support plate body, a first abutting block, and a second abutting block.

The first support plate body includes a first fastening surface and a first side surface and a second side surface that are disposed back to back, the first fastening surface is connected between the second side surface and the first side surface, the first fastening surface faces the first fastening bracket, and the first side surface faces the main shaft.

The first abutting block protrudes from the first fastening surface, and the second fitting surface is a part of a surface that is of the first abutting block and that faces the first side surface.

The second abutting block protrudes from the first fastening surface, and the fourth fitting surface is a part of a surface that is of the second abutting block and that faces the second side surface.

In a possible implementation, the first abutting block and the second abutting block are of an integrated structure. In this way, the first abutting block and the second abutting block are arranged more compactly on the first support plate body, and space utilization is high. In addition, a forming process of the first abutting block and the second abutting block is also simple.

In a possible implementation, the second fitting surface is disposed closer to the first side surface than to the second side surface. In this way, the second fitting surface is disposed close to the main shaft. A lap joint surface formed by the first fitting surface of the first connecting arm and the second fitting surface of the first support plate is disposed closer to the main shaft. In this way, the angle between the first support plate and the main shaft can be adjusted to a large degree by slightly increasing the magnitude of the interference between the first fitting surface of the first connecting arm and the second fitting surface of the first support plate, so that a form between the first support plate and the main shaft in the unfolded state of the folding mechanism can be better controlled, and precision of adjusting the angle between the first support plate and the main shaft in the unfolded state of the folding mechanism is also high.

In a possible implementation, the second fitting surface is disposed at an acute angle with the first fastening surface, and/or the fourth fitting surface is disposed at an acute angle with the first fastening surface.

It may be understood that the second fitting surface is disposed at the acute angle with the first fastening surface, so that the lap joint surface formed by the first fitting surface of the first connecting arm and the second fitting surface of the first support plate is disposed in an inclined manner. In this way, when the first fitting surface of the first connecting arm is in interference fit with the second fitting surface of the first support plate when the folding mechanism is in the unfolded state, acting force between the first fitting surface of the first connecting arm and the second fitting surface of the first support plate has greater acting force in a movement direction (for example, component force in a Z-axis direction is greater), so that the angle between the first support plate and the main shaft in the unfolded state of the folding mechanism can be better controlled, and the form between the first support plate and the main shaft in the unfolded state of the folding mechanism can be better controlled.

It may be understood that the fourth fitting surface is disposed at the acute angle with the first fastening surface, so that a lap joint surface formed by the third fitting surface of the first connecting arm and the fourth fitting surface of the first support plate is disposed in an inclined manner. In this way, when the third fitting surface of the first connecting arm is in interference fit with the fourth fitting surface of the first support plate when the folding mechanism is in the folded state, acting force between the third fitting surface of the first connecting arm and the fourth fitting surface of the first support plate has greater component force in a width direction of the folding mechanism, so that the opening angle of the first support plate can be larger. In this case, the screen-accommodating space enclosed by the first support plate, the main shaft, and the second support plate can be even larger. This better helps improve the reliability of the flexible display.

In a possible implementation, a first through hole is disposed on the first connecting arm, and when the folding mechanism is in the unfolded state, at least a part of the first abutting block is located in the first through hole. The first fitting surface of the first connecting arm is a part of a hole wall of the first through hole.

It may be understood that, compared with a solution in which a bump is disposed on the first connecting arm and the first fitting surface is formed on the bump, in this implementation, the first through hole is disposed on the first connecting arm, and the part of the hole wall of the first through hole is disposed as the first fitting surface. In this way, a volume of the first connecting arm does not increase to a large degree because of disposing of the bump on the first connecting arm.

In a possible implementation, the first connecting arm further has a bearing surface. When the folding mechanism is in the folded state, the bearing surface is disposed opposite to a part of the first support plate. In this way, when the folding mechanism in the folded state falls, the bearing surface of the first connecting arm can support the first support plate, to prevent the first support plate from falling in a direction close to the main shaft, and further prevent the first support plate from driving the flexible display to fall in a falling process. This ensures that the folding mechanism has better reliability when used in the folding mechanism.

In a possible implementation, the folding mechanism includes a second connecting arm, and the second connecting arm movably connects the second fastening bracket to the main shaft. The second connecting arm has a second fitting surface, the second support plate has a second fitting surface, and when the folding mechanism is in the unfolded state, the second fitting surface of the second connecting arm is in interference fit with the second fitting surface of the second support plate.

It may be understood that the first fitting surface of the second connecting arm is disposed to be in interference fit with the second fitting surface of the second support plate, so that the second support plate generates acting force in a movement direction. In this way, because there is a magnitude of interference set between the first fitting surface of the second connecting arm and the second fitting surface of the second support plate, acting force can be generated between the first fitting surface of the second connecting arm and the second fitting surface of the second support plate. Therefore, the acting force is used to control an angle between the second support plate and the main shaft, that is, control a form of the second support plate in the unfolded state of the folding mechanism. For example, the acting force between the first fitting surface of the second connecting arm and the second fitting surface of the second support plate may cause the angle between the second support plate and the main shaft to be equal to 180° as much as possible, to ensure that the flexible display is completely unfolded when the folding mechanism is used in the folding mechanism. In this way, the flexible display has good appearance consistency, to meet user experience. Therefore, this application provides the folding mechanism that can accurately adjust the angle in the unfolded state.

In a possible implementation, the folding mechanism includes a damping member, the damping member is disposed on the main shaft, and the damping member is configured to apply damping force to the first connecting arm and the second connecting arm.

It may be understood that, when the folding mechanism is in the folded state, the damping member applies the damping force to the first connecting arm and the second connecting arm. In this way, the first connecting arm and the second connecting arm are not likely to rotate relative to the main shaft under the action of the damping force. In other words, the first connecting arm and the second connecting arm can be well in a locked state. In this case, stability of interference fit between the first fitting surface of the first connecting arm and the second fitting surface of the first support plate is good, and stability of interference fit between the third fitting surface of the first connecting arm and the fourth fitting surface of the first support plate is good.

In a possible implementation, the first connecting arm includes a first large gear connecting rod, the first large gear connecting rod includes a sliding end and a rotating end, the sliding end of the first large gear connecting rod is slidably connected to the first fastening bracket, and the rotating end of the first large gear connecting rod is rotatably connected to the main shaft.

The second connecting arm includes a second large gear connecting rod, the second large gear connecting rod includes a sliding end and a rotating end, the sliding end of the second large gear connecting rod is slidably connected to the second fastening bracket, and the rotating end of the second large gear connecting rod is rotatably connected to the main shaft.

The folding mechanism further includes a first synchronization gear, a first clamping member, and a first elastic member.

The first synchronization gear is rotatably connected to the main shaft, and the rotating end of the first large gear connecting rod is meshed with the rotating end of the second large gear connecting rod via the first synchronization gear.

The first clamping member and the first elastic member are located on the main shaft, the first clamping member is located between the first elastic member and the first synchronization gear, and the first clamping member forms a clamping structure with both the rotating end of the first large gear connecting rod and the rotating end of the second large gear connecting rod.

The first elastic member is in a compressed state, and elastic force generated by the first elastic member causes the first clamping member to abut against the rotating end of the first large gear connecting rod and the rotating end of the second large gear connecting rod.

It may be understood that the rotating end of the first large gear connecting rod is connected to the rotating end of the second large gear connecting rod via a plurality of first synchronization gears, so that a rotation angle of the rotating end of the first large gear connecting rod and a rotation angle of the rotating end of the second large gear connecting rod have a same size and opposite directions, and rotation actions of the first large gear connecting rod and the second large gear connecting rod are kept synchronous relative to the main shaft, that is, the first large gear connecting rod and the second large gear connecting rod are synchronously close to or away from each other.

It may be understood that the first clamping member is disposed to form the clamping structure with both the rotating end of the first large gear connecting rod and the rotating end of the second large gear connecting rod, and the elastic force generated by the first elastic member causes the first clamping member to abut against the rotating end of the first large gear connecting rod and the rotating end of the second large gear connecting rod, to provide specific resistance in a process of unfolding or folding the folding mechanism, so that the user can experience a better sense of mechanism operation.

In a possible implementation, the folding mechanism further includes a first small gear connecting rod, a second small gear connecting rod, a second synchronization gear, a third clamping member, and a fourth clamping member.

A sliding end of the first small gear connecting rod is slidably connected to the first fastening bracket, a rotating end of the first small gear connecting rod is rotatably connected to the main shaft, a sliding end of the second small gear connecting rod is slidably connected to the second fastening bracket, and a rotating end of the second small gear connecting rod is rotatably connected to the main shaft.

The second synchronization gear is located on a side that is of the first elastic member and that is away from the first clamping member, and is rotatably connected to the main shaft, and the rotating end of the first small gear connecting rod is meshed with the rotating end of the second small gear connecting rod via the second synchronization gear.

The third clamping member and the fourth clamping member are located on the main shaft, the third clamping member is located between the first elastic member and the second synchronization gear, the fourth clamping member is located on a side that is of the second synchronization gear and that is away from the third clamping member, and the third clamping member and the fourth clamping member form a clamping structure with both the rotating end of the first small gear connecting rod and the rotating end of the second small gear connecting rod.

The first elastic member is in the compressed state, and the elastic force generated by the first elastic member further causes the third clamping member to abut against the rotating end of the first small gear connecting rod and the rotating end of the second small gear connecting rod.

It may be understood that the rotating end of the first small gear connecting rod is connected to the rotating end of the second small gear connecting rod via a plurality of second synchronization gears, so that a rotation angle of the rotating end of the first small gear connecting rod and a rotation angle of the rotating end of the second small gear connecting rod have a same size and opposite directions, and rotation actions of the first small gear connecting rod and the second small gear connecting rod are kept synchronous relative to the main shaft, that is, the first small gear connecting rod and the second small gear connecting rod are synchronously close to or away from each other.

It may be understood that the third clamping member and the fourth clamping member are disposed to form the clamping structure with both the rotating end of the first small gear connecting rod and the rotating end of the second small gear connecting rod, and the elastic force generated by the first elastic member further causes the third clamping member to abut against the rotating end of the first small gear connecting rod and the rotating end of the second small gear connecting rod, to provide the specific resistance in the process of unfolding or folding the folding mechanism, so that the user can experience the better sense of mechanism operation.

In a possible implementation, the first rotating member includes a rotating end and a sliding end, the rotating end of the first rotating member is rotatably connected to the main shaft, and the sliding end of the first rotating member is slidably connected to the first fastening bracket.

The first support plate is slidably connected to the sliding end of the first rotating member and rotates relative to the sliding end of the first rotating member.

The first rotating member includes a first abutting surface, the first support plate further includes a second abutting surface, and when the folding mechanism is in the unfolded state, the first abutting surface of the first rotating member is in interference fit with the second abutting surface of the first support plate.

It may be understood that, when the folding mechanism is in the unfolded state, the first abutting surface of the first rotating member abuts against the second abutting surface of the first support plate. The first abutting surface of the first rotating member and the second abutting surface of the first support plate form a lap joint surface. The first abutting surface of the first rotating member may be in interference fit with the second abutting surface of the first support plate, so that the first support plate generates the acting force in the movement direction. In this way, because there is a magnitude of interference set between the first abutting surface of the first rotating member and the second abutting surface of the first support plate, acting force can be generated between the first abutting surface of the first rotating member and the second abutting surface of the first support plate. Therefore, the acting force is used to control the angle between the first support plate and the main shaft, that is, control the form of the first support plate in the unfolded state of the folding mechanism. For example, the acting force between the first abutting surface of the first rotating member and the second abutting surface of the first support plate may cause the angle between the first support plate and the main shaft to be equal to 180° as much as possible, that is, it is ensured as much as possible that the flexible display is completely unfolded. In this way, the flexible display has good appearance consistency, to meet user experience.

In a possible implementation, the first support plate includes the first support plate body and a first movable block.

The first support plate body includes the first fastening surface and the second side surface and the first side surface that are disposed back to back, the first fastening surface is connected between the second side surface and the first side surface, the first fastening surface faces the first fastening bracket, and the first side surface faces the main shaft.

The first movable block protrudes from the first fastening surface of the first support plate body, and the first movable block has a first inclined hole.

The folding mechanism includes a pin shaft, two ends of the pin shaft are fastened to the sliding end of the first rotating member, a middle part of the pin shaft passes through the first inclined hole, and the middle part of the pin shaft slides in the first inclined hole of the first support plate and rotates relative to the first inclined hole.

The second abutting surface is a part of a surface that is of an outer ring surface of the first movable block and that faces the first side surface.

It may be understood that the first movable block can be connected to the first rotating member, and can also be in interference fit with the first fitting surface of the first connecting arm. The first movable block has "multi-purpose" effect.

In a possible implementation, the second abutting surface is disposed closer to the first side surface than to the second side surface. In this case, the second abutting surface is disposed close to the main shaft. The lap joint surface formed by the first abutting surface of the first rotating member and the second abutting surface of the first support plate is disposed closer to the main shaft. In this way, the angle between the first support plate and the main shaft can be adjusted to a large degree by slightly increasing the magnitude of the interference between the first abutting surface of the first rotating member and the second abutting surface of the first support plate, so that the form between the first support plate and the main shaft in the unfolded state of the folding mechanism can be better controlled, and the precision of adjusting the angle between the first support plate and the main shaft in the unfolded state of the folding mechanism is also high. For example, when the lap joint surface formed by the first abutting surface of the first rotating member and the second abutting surface of the first support plate is far away from the main shaft, the magnitude of the interference between the first abutting surface of the first rotating member and the second abutting surface of the first support plate needs to be set to 0.5 millimeters, so that the angle between the first support plate and the main shaft is 180°. When the lap joint surface formed by the first abutting surface of the first rotating member and the second abutting surface of the first support plate is close to the main shaft, the magnitude of the interference between the first abutting surface of the first rotating member and the second abutting surface of the first support plate is set to 0.2 millimeters, so that the angle between the first support plate and the main shaft is 180°.

In a possible implementation, the second abutting surface is disposed at an acute angle with the first fastening surface. In this way, the lap joint surface formed by the first abutting surface of the first rotating member and the second abutting surface of the first support plate is disposed in an inclined manner. In this way, when the first abutting surface of the first rotating member is in interference fit with the second abutting surface of the first support plate when the folding mechanism is in the unfolded state, acting force between the first abutting surface of the first rotating member and the second abutting surface of the first support plate has greater acting force in a movement direction (for example, component force in a Z-axis direction is greater), so that the angle between the first support plate and the main shaft in the unfolded state of the folding mechanism can be better controlled, and the form between the first support plate and the main shaft in the unfolded state of the folding mechanism can be better controlled.

In a possible implementation, the main shaft includes a first contact surface, and the first support plate includes a second contact surface. When the folding mechanism is in the unfolded state, the first contact surface abuts against the second contact surface. In this way, the main shaft can prevent the first support plate from continuing to rotate relative to the shaft, to assist in controlling the angle between the first support plate and the main shaft, so as to prevent the first support plate from forming a "V"-shaped included angle due to overfolding, that is, so as to control the angle between the first support plate and the main shaft to be 180° as much as possible.

In a possible implementation, the first contact surface is a part of a side surface of the main shaft, and the second contact surface is a part of the first side surface of the first support plate.

In a possible implementation, the first support plate includes the first support plate body and a first extension block. The first support plate body includes the second side surface and the first side surface that are disposed back to back, the first side surface faces the main shaft, and the first extension block protrudes from the first side surface. When the folding mechanism is in the unfolded state, the first extension block is disposed opposite to a part of the main shaft. In this way, when the folding mechanism falls, the first extension block can block the first support plate, to prevent the first support plate from continuing to fall.

In a possible implementation, the second rotating member includes a rotating end and a sliding end, the rotating end of the second rotating member is rotatably connected to the main shaft, and the sliding end of the second rotating member is slidably connected to the second fastening bracket. The second support plate is slidably connected to the sliding end of the second rotating member and rotates relative to the sliding end of the second rotating member. The second rotating member includes a third abutting surface, the second support plate further includes a fourth abutting surface, and the third abutting surface of the second rotating member is in interference fit with the fourth abutting surface of the second support plate.

It may be understood that, when the folding mechanism is in the unfolded state, the third abutting surface of the second rotating member abuts against the fourth abutting surface of the second support plate. The third abutting surface of the second rotating member and the fourth abutting surface of the second support plate form a lap joint surface. The third abutting surface of the second rotating member may be in interference fit with the fourth abutting surface of the second support plate, so that the second support plate generates the acting force in the movement direction. In this way, because there is a magnitude of interference set between the third abutting surface of the second rotating member and the fourth abutting surface of the second support plate, acting force can be generated between the third abutting surface of the second rotating member and the fourth abutting surface of the second support plate. Therefore, the acting force is used to control the angle between the second support plate and the main shaft, that is, control the form of the second support plate in the unfolded state of the folding mechanism. For example, the acting force between the third abutting surface of the second rotating member and the fourth abutting surface of the second support plate may cause the angle between the second support plate and the main shaft to be equal to 180° as much as possible, that is, it is ensured as much as possible that the flexible display is completely unfolded. In this way, the flexible display has good appearance consistency, to meet user experience.

According to a second aspect, this application provides an electronic device. The electronic device includes a first housing, a second housing, a flexible display, and the folding mechanism described above. The first fastening bracket is fastened to the first housing, and the second fastening bracket is fastened to the second housing.

The flexible display includes a first display region, a second display region, and a third display region that are sequentially connected to each other, the first display region is fastened to the first housing, and the third display region is fastened to the second housing. When the folding mechanism is in an unfolded state, the first support plate and the second support plate support the second display region. When the folding mechanism is in a folded state, the second display region is located in the screen-accommodating space.

It may be understood that the first fitting surface of the first connecting arm is disposed to be in interference fit with the second fitting surface of the first support plate, so that the first support plate generates acting force in a movement direction. In this way, because there is a magnitude of interference set between the first fitting surface of the first connecting arm and the second fitting surface of the first support plate, acting force can be generated between the first fitting surface of the first connecting arm and the second fitting surface of the first support plate. Therefore, the acting force is used to control an angle between the first support plate and the main shaft, that is, control a form of the first support plate in the unfolded state of the electronic device. For example, the acting force between the first fitting surface of the first connecting arm and the second fitting surface of the first support plate may cause the angle between the first support plate and the main shaft to be equal to 180° as much as possible, to ensure that the flexible display is completely unfolded. In this way, the flexible display has good appearance consistency, to meet user experience. Therefore, this application provides the folding mechanism that can accurately adjust the angle in the unfolded state.

### BRIEF DESCRIPTION OF DRAWINGS

FIG. 1 is a diagram of a structure of an electronic device in an unfolded state according to an implementation of this application;
FIG. 2 is a partially sectional view of the electronic device shown in FIG. 1 at an A-A line according to an implementation;
FIG. 3 is a diagram of a structure of the electronic device shown in FIG. 1 in a folded state according to an implementation;
FIG. 4 is a partially sectional view of the electronic device shown in FIG. 3 at a B-B line according to an implementation;
FIG. 5 is a partially exploded view of the electronic device shown in FIG. 1 according to an implementation;
FIG. 6 is a partially exploded view of a folding mechanism shown in FIG. 5 according to an implementation;
FIG. 7 is a diagram of a structure of the folding mechanism shown in FIG. 6 from another angle;
FIG. 8 is a partially exploded view of the folding mechanism shown in FIG. 7 according to an implementation;
FIG. 9 is a diagram of a partial structure of a main shaft shown in FIG. 7 according to an implementation;
FIG. 10 is a partially sectional view of the main shaft shown in FIG. 9 at a C-C line according to an implementation;
FIG. 11 is a partially exploded view of an end part connecting component shown in FIG. 8 according to an implementation;
FIG. 12 is a partially exploded view of the end part connecting component shown in FIG. 11 from another angle;
FIG. 13 is an enlarged diagram of a first rotating member and a second rotating member shown in FIG. 11;
FIG. 14 is a diagram 1 of a partial structure of the folding mechanism shown in FIG. 7 according to an implementation;
FIG. 15 is a partially sectional view of the folding mechanism shown in FIG. 7 at a D-D line according to an implementation;
FIG. 16 is an enlarged diagram of a first support plate shown in FIG. 8 at M1 according to an implementation;
FIG. 17 is a diagram 2 of a partial structure of the folding mechanism shown in FIG. 7 according to an implementation;
FIG. 18 is a diagram of a structure of the folding mechanism shown in FIG. 17 from another angle;
FIG. 19 is a partially sectional view of the folding mechanism shown in FIG. 17 at an E-E line according to an implementation;
FIG. 20 is a partially sectional view of the folding mechanism shown in FIG. 17 at an F-F line according to an implementation;
FIG. 21 is a partially sectional view of the folding mechanism shown in FIG. 18 at a G-G line according to an implementation;
FIG. 22 is an enlarged diagram of the first support plate shown in FIG. 8 at M2 according to an implementation;
FIG. 23 is a diagram of structures of a first large gear connecting rod and a first small gear connecting rod shown in FIG. 11 according to an implementation;
FIG. 24 is a diagram of structures of the first small gear connecting rod and a second small gear connecting rod shown in FIG. 11 according to an implementation;
FIG. 25 is a partially exploded view of a damping member shown in FIG. 11 according to an implementation;
FIG. 26 is a diagram 3 of a partial structure of the folding mechanism shown in FIG. 7 according to an implementation;
FIG. 27 is a diagram 4 of a partial structure of the folding mechanism shown in FIG. 7 according to an implementation;
FIG. 28 is a diagram of a structure of the first large gear connecting rod shown in FIG. 11 according to another implementation;
FIG. 29 is a diagram of a structure of the first large gear connecting rod shown in FIG. 28 from another angle;
FIG. 30 is an enlarged diagram of the first support plate shown in FIG. 8 at M3 according to an implementation;
FIG. 31 is a partially sectional view of the folding mechanism shown in FIG. 27 at an H-H line according to an implementation;
FIG. 32 is a partially sectional view of the electronic device shown in FIG. 3 at an I-I line according to an implementation;
FIG. 33 is a diagram of a structure of the first large gear connecting rod shown in FIG. 11 according to still another implementation; and
FIG. 34 is a partially sectional view of the electronic device shown in FIG. 3 at a J-J line according to an implementation.

### DESCRIPTION OF EMBODIMENTS

The following clearly and completely describes technical solutions in embodiments of this application with reference to accompanying drawings in embodiments of this application.

In descriptions of this application, it should be noted that, unless otherwise specified and limited, terms "mounting", "connecting", and "connection" should be understood in a broad sense. For example, "connection" may be a detachable connection, or may be an non-detachable connection; or may be a direct connection, or may be an indirect connection by using an intermediate medium; or may be an electrical connection, or may be a mechanical connection. "Fastening" means that two parts are connected to each other and a relative position relationship remains unchanged after the two parts are connected to each other. "Rotatable connection" means that two parts are connected to each other and can rotate relative to each other after the two parts are connected to each other. "Slidable connection" means that two parts are connected to each other and can slide relative to each other after the two parts are connected to each other. "Movable connection" means that two parts are connected to each other and can move relative to each other after the two parts are connected to each other. In addition, obtaining an integrated structure of two parts through an integral forming process means that, in a process of forming one of the two parts, the part is connected to the other part, and the two parts are connected without secondary processing (for example, bonding, welding, snap-fitting, or screwing). That a part A is disposed opposite to a part B may be that the part A is projected along a target direction to obtain projection C, the part B is projected along a target direction to obtain projection D, and the projection C and the projection D may at least largely overlap. In some embodiments, largely overlapping may be any one of the following cases: The projection C is completely located in the projection D; or the projection D is completely located in the projection C; or the projection C and the projection D cross each other, and a proportion of a crossing region of the projection C and the projection D to the projection C or the projection D is greater than 50%.

Orientation terms mentioned in embodiments of this application, for example, "top", "bottom", "inside", and "outside" are directions with reference to the accompanying drawings. Therefore, the orientation term is used to better and more clearly describe and understand embodiments of this application, instead of indicating or implying that a specified apparatus or element should have a specific orientation, and be constructed and operated in the specific orientation. Therefore, this cannot be understood as a limitation on embodiments of this application. A person of ordinary skill in the art may understand specific meanings of the foregoing terms based on specific cases.

In the specification and claims of this application, terms "first", "second", and the like are intended to distinguish between similar objects but do not indicate a specific order or sequence. It should be understood that the data termed in such a way is interchangeable in proper circumstances, so that embodiments of this application can be implemented in an order other than the order illustrated or described herein. In addition, the objects distinguished by "first", "second", and the like are usually of one type, and a quantity of objects is not limited, for example, there may be one or more first objects. In addition, in the specification and claims, "and/or" indicates at least one of connected objects, and a character "/" usually indicates an "or" relationship between associated objects. "A plurality of" means at least two.

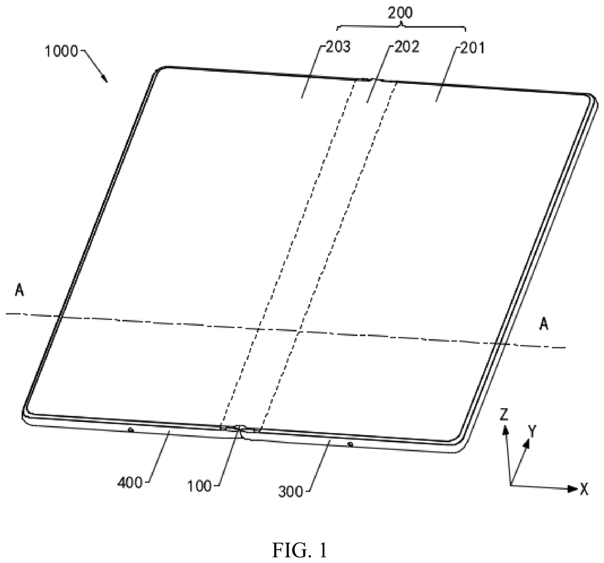

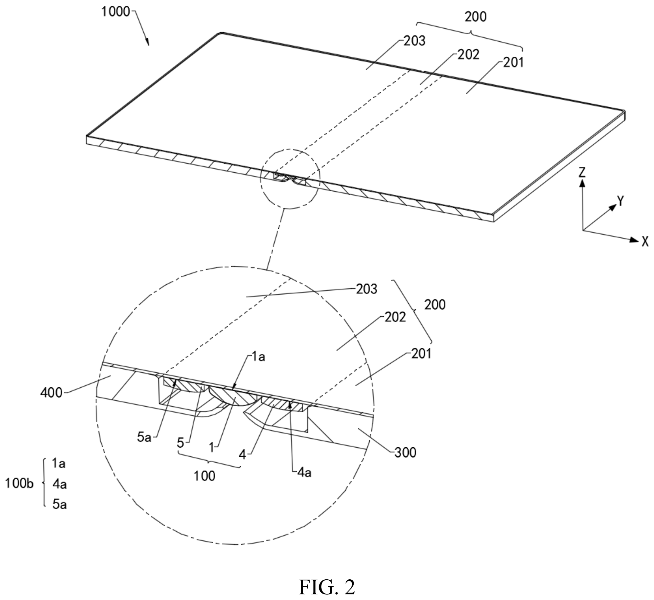

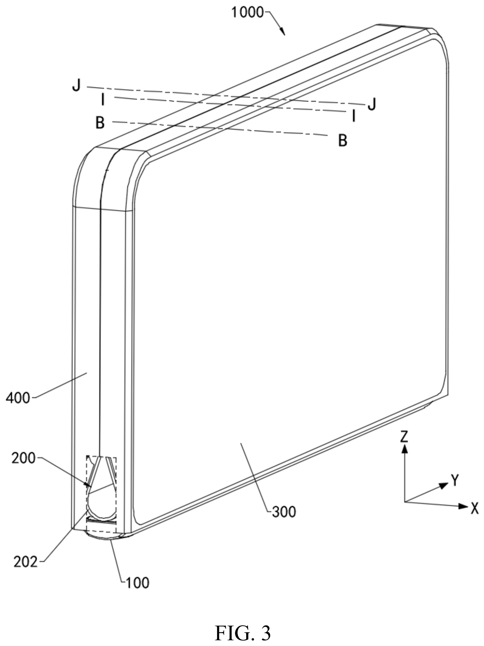

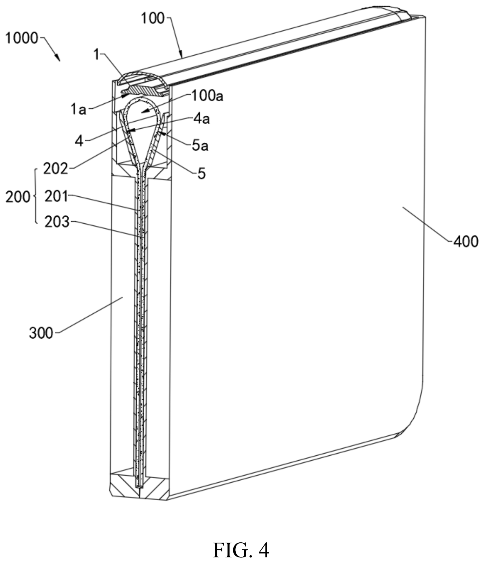

FIG. 1 is a diagram of a structure of an electronic device 1000 in an unfolded state according to an implementation of this application. FIG. 2 is a partially sectional view of the electronic device 1000 shown in FIG. 1 at an A-A line according to an implementation. FIG. 3 is a diagram of a structure of the electronic device 1000 shown in FIG. 1 in a folded state according to an implementation. FIG. 4 is a partially sectional view of the electronic device 1000 shown in FIG. 3 at a B-B line according to an implementation.

As shown in FIG. 1 to FIG. 4, this application provides a foldable electronic device 1000. The foldable electronic device 1000 may be a foldable device like a mobile phone, a tablet computer, a personal computer, a notebook computer, a vehicle-mounted device, or a wearable device (for example, a smart band). In embodiments of this application, an example in which the electronic device 1000 is a mobile phone is used for detailed description.

For ease of description, for example, a thickness direction of the electronic device 1000 is defined as a Z-axis direction, and an extension direction of a rotation axis of the electronic device 1000 is defined as a Y-axis direction, that is, a width direction of the electronic device 1000 is defined as the Y-axis direction. A direction perpendicular to the Y-axis direction and the Z-axis direction is an X-axis direction, that is, a length direction of the electronic device 1000 is an X-axis. It may be understood that a coordinate system of the electronic device 1000 may alternatively be flexibly set based on a specific requirement. For example, the Z-axis direction is defined as a first direction, the X-axis direction is defined as a second direction, and the Y-axis direction is defined as a third direction. In another implementation, the first direction, the second direction, and the third direction may alternatively be flexibly set based on a requirement, provided that the first direction, the second direction, and the third direction intersect with each other.

It may be understood that, in this implementation, the direction of the rotation axis of the electronic device 1000 is the Y-axis direction, that is, the electronic device 1000 may be unfolded or folded relatively in the Y-axis direction. In this way, when the electronic device 1000 is in a folded state, a dimension of the electronic device 1000 in the X-axis direction becomes smaller. This embodiment is described by using an example in which "the direction of the rotation axis of the electronic device 1000 is the Y-axis direction". In this case, the electronic device 1000 can be folded left and right, and folding and unfolding of the electronic device 1000 affect a length dimension of the electronic device 1000. In some other embodiments, the rotation axis of the electronic device 1000 may alternatively be in the X-axis direction. In other words, the electronic device 1000 may be unfolded or folded relatively in the X-axis direction. In this case, the electronic device 1000 can be folded up and down, and folding and unfolding of the electronic device 1000 affect a width dimension of the electronic device 1000.

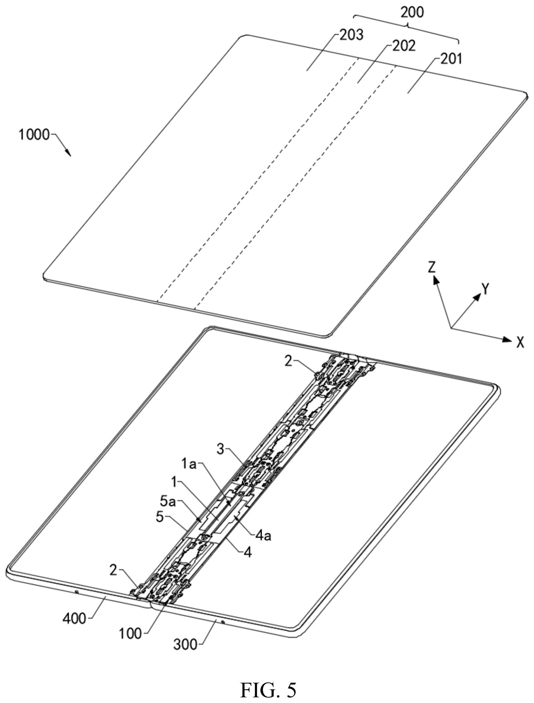

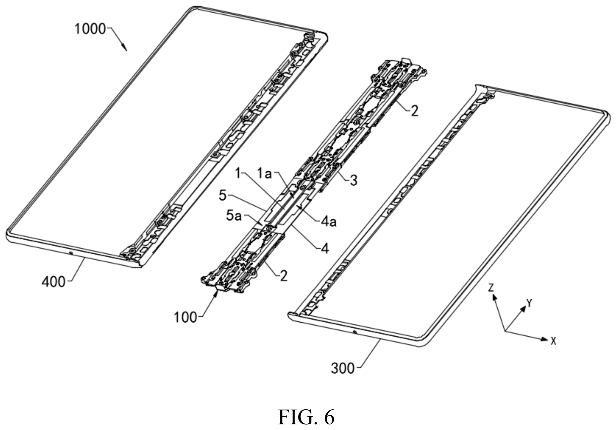

FIG. 5 is a partially exploded view of the electronic device 1000 shown in FIG. 1 according to an implementation. FIG. 6 is a partially exploded view of a folding mechanism 100 shown in FIG. 5 according to an implementation.

As shown in FIG. 5 and FIG. 6, the electronic device 1000 includes the folding mechanism 100, a flexible display 200, a first housing 300, and a second housing 400. The flexible display 200 may be an organic light-emitting diode (organic light-emitting diode, OLED) display, an active-matrix organic light-emitting diode (active-matrix organic light-emitting diode, AMOLED) display, a mini organic light-emitting diode (mini organic light-emitting diode) display, a micro organic light-emitting diode (micro light-emitting diode) display, a quantum dot light-emitting diode (quantum dot light-emitting diode, QLED) display, or the like. In addition, the folding mechanism 100 may be an inward folding mechanism, or may be an outward folding mechanism. The inward folding mechanism may be a folding mechanism that folds at least a part of the flexible display 200 between the first housing 300 and the second housing 400. The outward folding mechanism may be a folding mechanism that folds at least a part of the flexible display 200 to the outside of the first housing 300 and the second housing 400. A specific structure of the folding mechanism 100 is not limited in this application. In this implementation, an example in which the folding mechanism 100 is an inward folding mechanism is used for description. For example, a thickness direction of the folding mechanism 100 may be the Z-axis direction, and a length direction of the folding mechanism 100 may be the Y-axis direction. A width direction of the folding mechanism 100 may be the X-axis direction.

As shown in FIG. 5 and FIG. 6, for example, the folding mechanism 100 is connected between the first housing 300 and the second housing 400. The folding mechanism 100 is configured to unfold or fold the first housing 300 and the second housing 400 relative to each other.

As shown in FIG. 1 and FIG. 2, when the first housing 300 and the second housing 400 are unfolded relative to each other to the unfolded state, the electronic device 1000 is in the unfolded state, and the first housing 300 and the second housing 400 may be at 180°. In another embodiment, there may alternatively be a slight deviation from 180° between the first housing 300 and the second housing 400. For example, the first housing 300 and the second housing 400 may be at 165°, 177°, or 185°.

As shown in FIG. 3 and FIG. 4, when the first housing 300 and the second housing 400 are folded relative to each other to a closed state, the electronic device 1000 is in the folded state, the first housing 300 and the second housing 400 may be closed to each other, and there may be no large gap between the first housing 300 and the second housing 400. In this way, the electronic device 1000 has good appearance experience, and has good waterproof, dustproof, and foreign object prevention performance. A case in which the first housing 300 and the second housing 400 are closed includes a case in which the first housing 300 and the second housing 400 abut against each other, or may include a case in which there is a small gap between the first housing 300 and the second housing 400. When there is a small gap between the first housing 300 and the second housing 400, some foreign objects outside the electronic device 1000 do not enter between the first housing 300 and the second housing 400 through the gap.

The first housing 300 and the second housing 400 may alternatively be unfolded or folded relative to each other to an intermediate state, so that the electronic device 1000 is in the intermediate state. The intermediate state may be any state between the unfolded state and the folded state.

Refer to FIG. 5. With reference to FIG. 1 to FIG. 4, the flexible display 200 includes a first display region 201, a second display region 202, and a third display region 203. The second display region 202 is connected between the first display region 201 and the third display region 203. In FIG. 1, FIG. 2, and FIG. 5, a first display region 201, a second display region 202, and a third display region 203 are schematically distinguished by using dashed lines. The first display region 201 of the flexible display 200 is fastened to the first housing 300. The third display region 203 is fastened to the second housing 400. In a process in which the first housing 300 and the second housing 400 are unfolded or folded relative to each other, the first housing 300 may drive the first display region 201 to move, the second housing 400 may drive the third display region 203 to move, the first display region 201 and the third display region 203 are unfolded or folded relative to each other, and the second display region 202 can be deformed.

It may be understood that, because the first display region 201 is fastened to the first housing 300, and the third display region 203 is fastened to the second housing 400, when the first housing 300 and the second housing 400 are unfolded or folded relative to each other, actions of relative unfolding and folding between the first display region 201 and the third display region 203 can be accurately controlled, so that a folding process and a movement form of the flexible display 200 are controllable, and reliability is high.

As shown in FIG. 1 and FIG. 2, when the electronic device 1000 is in the unfolded state, the flexible display 200 may be in the unfolded state. For example, the first display region 201, the second display region 202, and the third display region 203 of the flexible display 200 may be at 180°. In another embodiment, there may alternatively be a slight deviation from 180° between the first display region 201, the second display region 202, and the third display region 203. For example, the first display region 201, the second display region 202, and the third display region 203 may be at 165°, 177°, or 185°. In this case, the flexible display 200 has a continuous large-area display region, that is, the flexible display 200 can implement large-screen displaying, and therefore, user experience is good.

For example, when the electronic device 1000 is in the unfolded state, at least a part of the folding mechanism 100 may be configured to support the second display region 202. In this way, when the second display region 202 is subject to pressing force, squeezing force, impact force, or the like, the folding mechanism 100 may be configured to improve a pressure resistance capability and an impact resistance capability of the second display region 202, that is, ensure that the second display region 202 is not prone to a problem like a dent.

As shown in FIG. 3 and FIG. 4, when the electronic device 1000 is in the folded state, the flexible display 200 may be in the folded state. For example, the first display region 201 and the third display region 203 of the flexible display 200 approach each other. The second display region 202 is in a bent shape. In this case, the flexible display 200 may be approximately in a "water drop" shape. In addition, the flexible display 200 is located in a space enclosed by the first housing 300, the folding mechanism 100, and the second housing 400. The first display region 201 and the third display region 203 are located between the first housing 300 and the second housing 400. In this case, a planar dimension of the electronic device 1000 is small (with a small width dimension), so that it is convenient for a user to carry and accommodate the electronic device 1000.

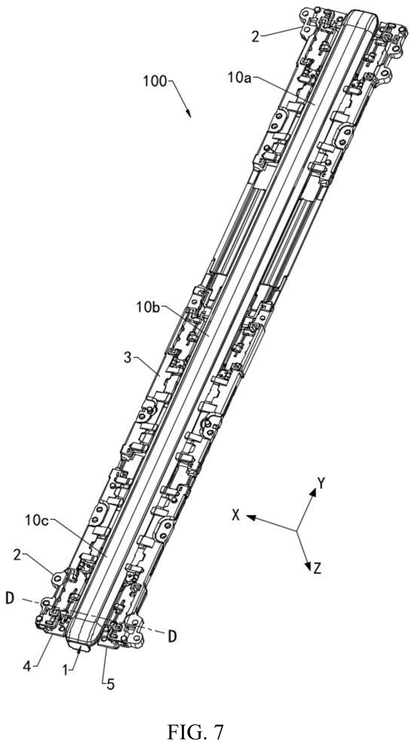

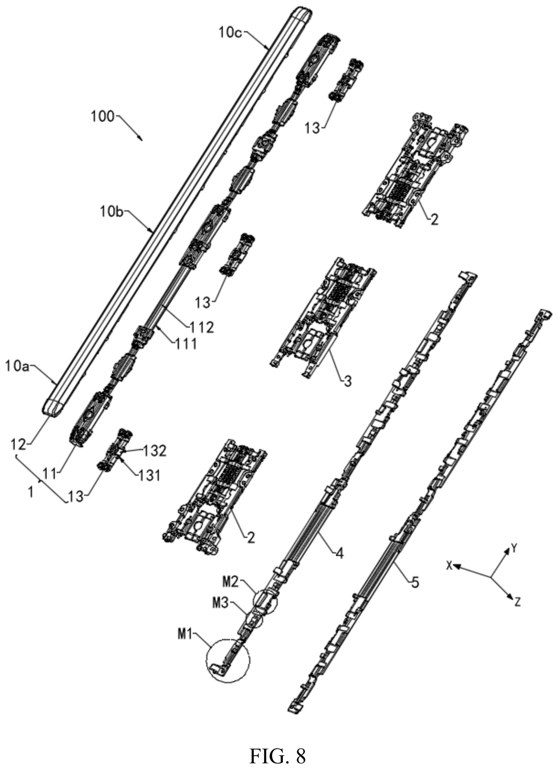

FIG. 7 is a diagram of a structure of the folding mechanism 100 shown in FIG. 6 from another angle. FIG. 8 is a partially exploded view of the folding mechanism 100 shown in FIG. 7 according to an implementation.

Refer to FIG. 7 and FIG. 8. With reference to FIG. 5 and FIG. 6, the folding mechanism 100 includes a main shaft 1, an end part connecting component 2, a middle part connecting component 3, a first support plate 4, and a second support plate 5. A length extension direction of the main shaft 1 may be the Y-axis direction.

For example, the main shaft 1 is located between the first housing 300 and the second housing 400. The end part connecting component 2 is connected to the first housing 300, the main shaft 1, and the second housing 400. There are two end part connecting components 2, and the two end part connecting components 2 are spaced in the length extension direction of the main shaft 1, for example, may be respectively connected to a top and a bottom of the main shaft 1. It may be understood that the end part connecting component 2 may be mainly configured to unfold or fold the first housing 300 and the second housing 400 relative to each other. The following specifically describes a structure of the end part component with reference to related accompanying drawings. Details are not described herein.

For example, structures of the two end part connecting components 2 are mirror-symmetrical. In this case, because the structures of the two end part connecting components 2 are the same, an overall structure of the folding mechanism 100 is simple and processing costs are low. Because the two end part connecting components 2 are mirror-symmetrically arranged, in a rotation process of the folding mechanism 100, stress between the two end part connecting components 2 and the main shaft 1, the first housing 300, and the second housing 400 is even. This helps improve reliability of the folding mechanism 100. In some other embodiments, the structures of the two end part connecting components 2 may alternatively be different. In some other embodiments, in this embodiment of this application, only one end part connecting component 2 may be disposed, and is located at an end part of the folding mechanisms 100. It may be understood that the structure of the folding mechanism 100 may have a plurality of combination and variation manners. This is not strictly limited in embodiments of this application.

For example, the middle part connecting component 3 is connected to the first housing 300, the main shaft 1, and the second housing 400. The middle part connecting component 3 is located between the two end part connecting components 2. The middle part connecting component 3 may be configured to assist the end part connecting component 2, so that the first housing 300 and the second housing 400 are unfolded or folded relative to each other. A specific structure of the middle part connecting component 3 is not specifically limited in this application.

Refer to FIG. 7 and FIG. 8. With reference to FIG. 5 and FIG. 6, the first support plate 4 is located on a side that is of the main shaft 1 and that is close to the first housing 300. The first support plate 4 connects the main shaft 1 to the first housing 300 via the end part connecting component 2 and the middle part connecting component 3. A specific manner in which the first support plate 4 is connected to the first housing 300 and the end part connecting component 2 is described below in detail with reference to related accompanying drawings. Details are not described herein. In addition, the specific structure of the middle part connecting component 3 is not limited in this implementation. Therefore, a manner in which the first support plate 4 is connected to the middle part connecting component 3 is determined based on the specific structure of the middle part connecting component 3. Details are also not described herein.

In addition, the second support plate 5 is located on a side that is of the main shaft 1 and that is close to the second housing 400. The second support plate 5 connects the second housing 400 to the main shaft 1 via the end part connecting component 2 and the middle part connecting component 3. It may be understood that the second support plate 5 and the first support plate 4 may be of a same or similar structure, a symmetrical or partially symmetrical structure, or different structures. In this implementation, the second support plate 5 and the first support plate 4 are of a symmetrical structure. For a basic design of a part structure of the second support plate 5, a design of a connection relationship between parts, and a design of a connection relationship between a part and another structure outside the component, refer to a related solution of the first support plate 4. In addition, the second support plate 5 and the first support plate 4 are allowed to be slightly different in detailed structures or position arrangement of parts. Details are not described herein again.

As shown in FIG. 5 and FIG. 6, for example, the main shaft 1 includes a first support surface 1a. The first support surface 1a may be a plane. The first support plate 4 has a second support surface 4a. The second support surface 4a may be a plane. The second support plate 5 has a third support surface 5a. The third support surface 5a may be a plane.

As shown in FIG. 2, when the first housing 300 and the second housing 400 are unfolded relative to each other to the unfolded state (that is, the electronic device 1000 is in the unfolded state), the main shaft 1 is located between the first support plate 4 and the second support plate 5, and the first support plate 4 and the second support plate 5 are unfolded relative to the main shaft 1. The first support surface 1a of the main shaft 1, the second support surface 4a of the first support plate 4, and the third support surface 5a of the second support plate 5 form a support surface 100b, and the support surface 100b supports the second display region 202 of the flexible display 200. Therefore, when the second display region 202 is touched, the second display region 202 is not prone to a problem like damage or a dent caused by external force touch, thereby significantly improving the reliability of the flexible display 200.

For example, when the electronic device 1000 is in the unfolded state, the first support surface 1a of the main shaft 1, the second support surface 4a of the first support plate 4, and the third support surface 5a of the second support plate 5 may be aligned with each other. In this case, flatness of the flexible display 200 is good, and user experience is good.

As shown in FIG. 4, when the electronic device 1000 is in the folded state, the main shaft 1 is located between the first support plate 4 and the second support plate 5, the first support plate 4 and the second support plate 5 are located on a same side of the main shaft 1, and the first support plate 4 and the second support plate 5 approach each other. The main shaft 1, the first support plate 4, and the second support plate 5 may enclose a screen-accommodating space 100a. The second display region 202 of the flexible display 200 may be located in the screen-accommodating space 100a.

For example, an end part that is of the first support plate 4 and that is away from the main shaft 1 and an end part that is of the second support plate 5 and that is away from the main shaft 1 are close to each other. In an implementation, the first support surface 1a of the main shaft 1, the second support surface 4a of the first support plate 4, and the third support surface 5a of the second support plate 5 may enclose a cross section in a triangle shape. The first support plate 4 and the second support plate 5 may jointly act on the second display region 202 of the flexible display 200, so that the first display region 201 and the third display region 203 of the flexible display 200 can be close to each other, and even can be attached to each other, to make the flexible display 200 in the "water drop" shape. In another embodiment, the shape of the cross section enclosed by the first support surface 1a of the main shaft 1, the second support surface 4a of the first support plate 4, and the third support surface 5a of the second support plate 5 may alternatively be in another shape. This is not specifically limited in this application.

It may be understood that, regardless of whether the electronic device 1000 is in the unfolded state or the folded state, an arrangement manner of the main shaft 1, the first support plate 4, and the second support plate 5 affects a shape of the second display region 202, an angle between the second display region 202 and the first display region 201, an angle between the second display region 202 and the third display region 203, and the like. The arrangement manner of the main shaft 1, the first support plate 4, and the second support plate 5 plays a key role in a form of the flexible display 200 in the unfolded state or the folded state of the electronic device 1000. In this application, the arrangement manner of the main shaft 1, the first support plate 4, and the second support plate 5 is adjusted by setting structures of some parts (including the main shaft 1, the first support plate 4, the second support plate 5, and the like) of the folding mechanism 100 and through fitting between the parts. In this way, the form of the flexible display 200 is better controlled, and an appearance of the flexible display 200 better meets a user requirement, that is, the electronic device 1000 is highly delicate, and user experience of the electronic device 1000 is good. The arrangement manner of the main shaft 1, the first support plate 4, and the second support plate 5 may be an angle between the first support plate 4 and the main shaft 1, an angle between the second support plate 5 and the main shaft 1, an angle between the first support plate 4 and the second support plate 5, or the like.

As shown in FIG. 7 and FIG. 8, the main shaft 1 includes a first end part 10a, a middle part 10b, and a second end part 10c that are sequentially connected. The first end part 10a and the second end part 10c of the main shaft 1 may be respectively configured to connect the two end part connecting components 2. The middle part 10b of the main shaft 1 may be configured to connect the middle part connecting component 3.

It may be understood that the first end part 10a and the second end part 10c of the main shaft 1 may be of a same or similar structure, a symmetrical or partially symmetrical structure, or different structures. For example, the first end part 10a and the second end part 10c of the main shaft 1 are of a symmetrical structure. For a basic design of a part structure of the second end part 10c of the main shaft 1, a design of a connection relationship between parts, and a design of a connection relationship between a part and another structure outside the component, refer to a related solution of the first end part 10a of the main shaft 1. In addition, the first end part 10a and the second end part 10c of the main shaft 1 are allowed to be slightly different in detailed structures or position arrangement of parts. Details are not described herein again. In addition, a structure of the middle part 10b of a base may be determined based on the structure of the middle part connecting component 3. This is not specifically limited in this application.

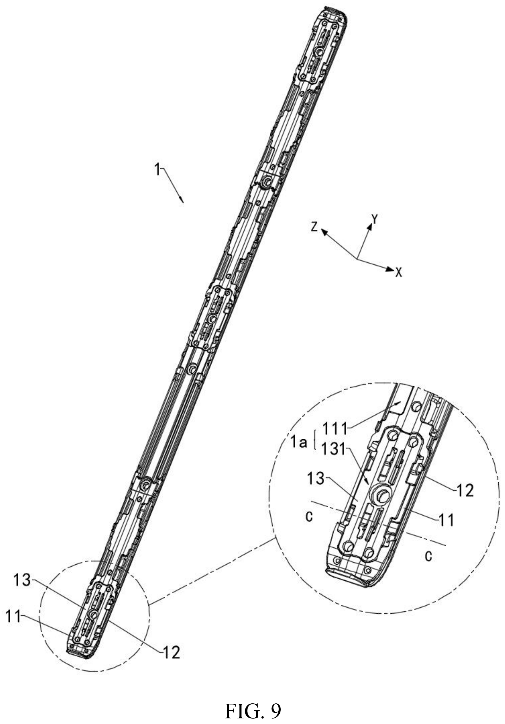

FIG. 9 is a diagram of a partial structure of the main shaft 1 shown in FIG. 7 according to an implementation.

As shown in FIG. 8 and FIG. 9, in some embodiments, the main shaft 1 includes a base 11, a bottom housing 12, and an upper cover 13. For example, there may be three upper covers 13. In another implementation, a quantity of upper covers 13 is not specifically limited.

For example, the base 11 includes a top surface 111 and a bottom surface 112. The bottom surface 112 of the base 11 is connected to the top surface 111 of the base 11. The top surface 111 of the base 11 is a surface that is of the base 11 and that faces the flexible display 200. The bottom surface 112 of the base 11 is a surface that is of the base 11 and that faces away from the flexible display 200.

For example, the upper cover 13 includes a top surface 131 and a bottom surface 132. The bottom surface 132 of the upper cover 13 is connected to the top surface 131 of the upper cover 13. The top surface 131 of the upper cover 13 is a surface that is of the upper cover 13 and that faces the flexible display 200. The bottom surface 132 of the upper cover 13 is a surface that is of the upper cover 13 and that faces away from the flexible display 200.

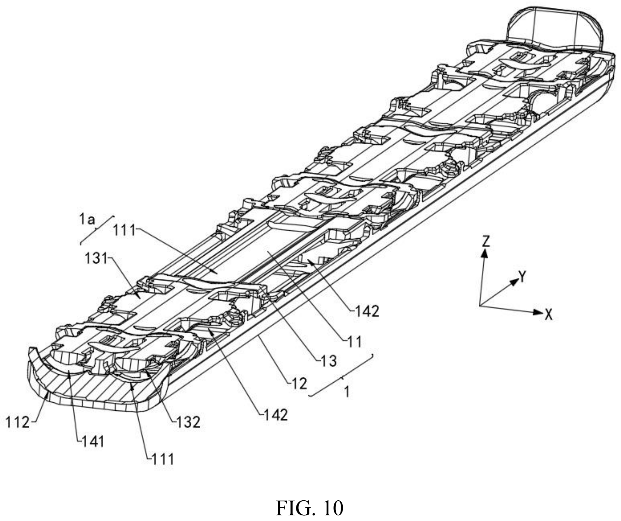

FIG. 10 is a partially sectional view of the main shaft 1 shown in FIG. 9 at a C-C line according to an implementation.

As shown in FIG. 9 and FIG. 10, the upper cover 13 is fastened to the base 11. It may be understood that the bottom surface 132 of the upper cover 13 faces the top surface 111 of the base 11. A part of the bottom surface 132 of the upper cover 13 and a part of the top surface 111 of the base 11 are disposed opposite to and spaced from each other, and enclose an arc-shaped groove 141. The top surface 131 of the upper cover 13 and the top surface 111 of the base 11 may be spliced into the first support surface 1a of the main shaft 1. In an implementation, the top surface 131 of the upper cover 13 may be aligned with the top surface 111 of the base 11.

In an implementation, the base 11 is fastened to the upper cover 13 by using a fastener (not shown in the figure). The fastener may be a screw, a screw bolt, a rivet, a pin, or the like.

As shown in FIG. 9 and FIG. 10, the bottom housing 12 is fastened to the base 11. It may be understood that an inner surface of the bottom housing 12 faces the bottom surface 112 of the base 11. It may be understood that a plurality of three-dimensional space structures of the base 11 and a plurality of three-dimensional space structures of the bottom housing 12 jointly form a plurality of movable spaces 142 of the main shaft 1. For example, the movable spaces 142 with different structures may be used to fit with structural members with different structures, so that a connection structure between the main shaft 1 and the plurality of connecting components is more flexible and diversified. The movable spaces 142 with a same structure may be used to fit with structural members with a same structure. This helps reduce design difficulty and costs of the main shaft 1, the end part connecting component 2, and the middle part connecting component 3. FIG. 10 schematically marks numbers of some movable spaces 142.

In some embodiments, some bumps (not shown in the figure) of the base 11 have a limiting function. These bumps are located in the movable space 142, and are configured to limit the end part connecting component 2 and the middle part connecting component 3, to prevent the end part connecting component 2 and the middle part connecting component 3 from being accidentally detached from the main shaft 1, so as to improve connection reliability and movement reliability between the end part connecting component 2, the middle part connecting component 3, and the main shaft 1, and make the reliability of the folding mechanism 100 higher.

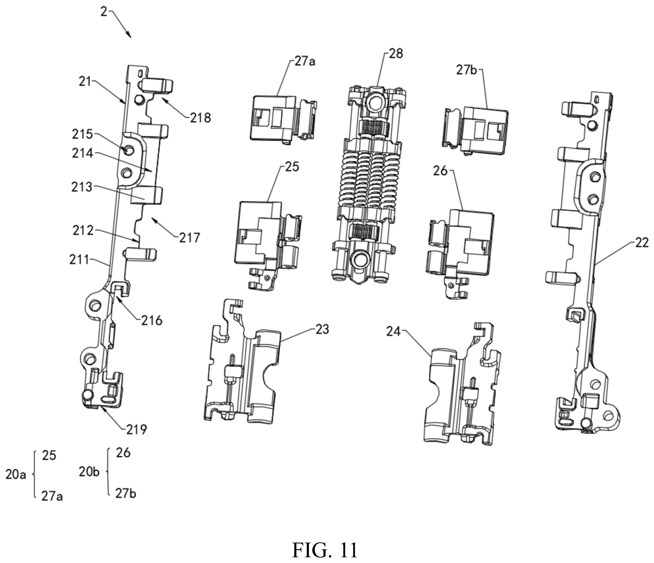

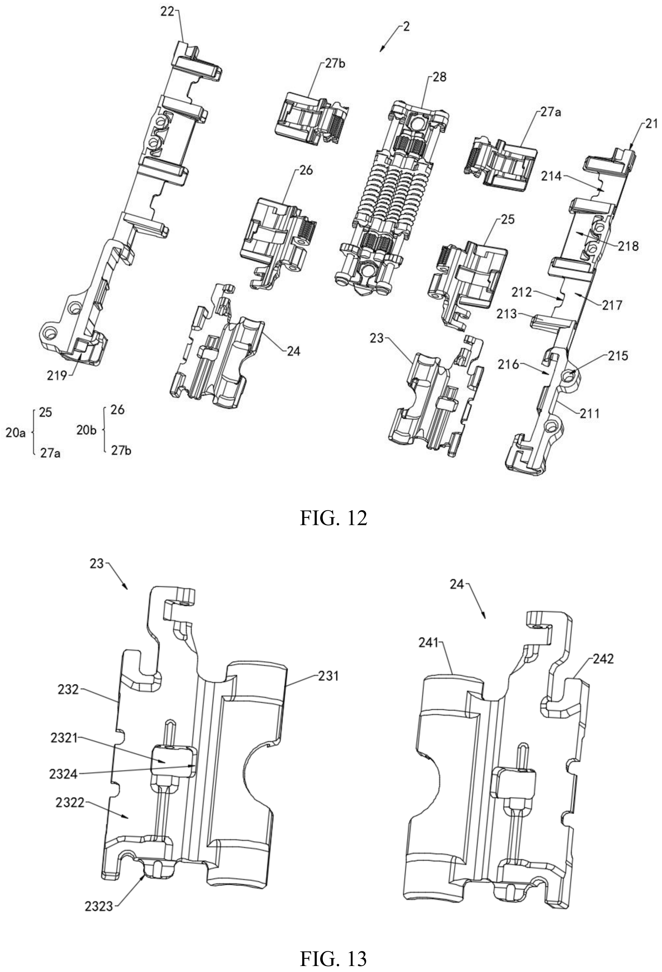

FIG. 11 is a partially exploded view of the end part connecting component 2 shown in FIG. 8 according to an implementation. FIG. 12 is a partially exploded view of the end part connecting component 2 shown in FIG. 11 from another angle.

As shown in FIG. 11 and FIG. 12, the end part connecting component 2 includes a first fastening bracket 21, a second fastening bracket 22, a first rotating member 23, a second rotating member 24, a first large gear connecting rod 25, a second large gear connecting rod 26, a first small gear connecting rod 27a, a second small gear connecting rod 27b, and a damping member 28.

It may be understood that both the first large gear connecting rod 25 and the first small gear connecting rod 27a may be used as structures of a first connecting arm 20a of the folding mechanism 100. In other words, the first connecting arm 20a may include the first large gear connecting rod 25 or the first small gear connecting rod 27a. Certainly, the first connecting arm 20a may further include a first connecting piece in another position of the folding mechanism 100. The first connecting piece is movably connected to the main shaft 1 and the first fastening bracket 21. A specific position of the first connecting arm 20a is not limited in this application.

In addition, both the second large gear connecting rod 26 and the second small gear connecting rod 27b may be used as structures of a second connecting arm 20b of the end part connecting component 2. In other words, the second connecting arm 20b may include the second large gear connecting rod 26 or the second small gear connecting rod 27b. Certainly, the second connecting arm 20b may further include a second connecting piece in another position of the folding mechanism 100. The second connecting piece is movably connected to the main shaft 1 and the second fastening bracket 22. A specific position of the second connecting arm 20b is not limited in this application.

In some implementations, the end part connecting component 2 may include more or fewer structures. For example, the end part connecting component 2 may not include the first rotating member 23, the second rotating member 24, the first small gear connecting rod 27a, the second small gear connecting rod 27b, or the like.

As shown in FIG. 11 and FIG. 12, the first fastening bracket 21 includes a first fastening bracket body 211, a plurality of through holes 212, a plurality of bumps 213, a plurality of grooves 214, and a plurality of fastening holes 215. The plurality of through holes 212, the plurality of bumps 213, and the plurality of grooves 214 are formed on the first fastening bracket body 211. The plurality of through holes 212, the plurality of bumps 213, and the plurality of grooves 214 are combined with each other to form a first sliding space 216, a second sliding space 217, a third sliding space 218, and an arc-shaped space 219 that are spaced. In addition, the plurality of fastening holes 215 are formed on the first fastening bracket body 211. FIG. 11 and FIG. 12 schematically mark numbers of some through holes 212, some bumps 213, some grooves 214, and some fastening holes 215.

It may be understood that the second fastening bracket 22 and the first fastening bracket 21 may be of a same structure, a symmetrical structure, a partially symmetrical structure, or different structures. This is not strictly limited in this application. For example, the second fastening bracket 22 and the first fastening bracket 21 may be of a symmetrical structure. For a basic design of a part structure of the second fastening bracket 22, a design of a connection relationship between parts, and a design of a connection relationship between a part and another structure outside the component, refer to a related solution of the first fastening bracket 21. In addition, the second fastening bracket 22 and the first fastening bracket 21 are allowed to be slightly different in detailed structures or position arrangement of parts.

FIG. 13 is an enlarged diagram of the first rotating member 23 and the second rotating member 24 shown in FIG. 11.

As shown in FIG. 13, the first rotating member 23 includes a rotating end 231 and a sliding end 232 connected to the rotating end 231. For example, the rotating end 231 of the first rotating member 23 may be in an arc shape. The sliding end 232 of the first rotating member 23 may be in a sliding block shape.

For example, a first avoidance hole 2321 is disposed at the sliding end 232 of the first rotating member 23. The first avoidance hole 2321 penetrates from a top surface 2322 of the sliding end 232 of the first rotating member 23 to a bottom surface 2323 of the sliding end 232 of the first rotating member 23.

For example, a hole wall of the first avoidance hole 2321 includes a first abutting surface 2324. The first abutting surface 2324 is a part of the hole wall that is of the first avoidance hole 2321 and that is close to the rotating end 231 of the first rotating member 23. The first abutting surface 2324 is inclined to a direction of the rotating end 231 of the first rotating member 23, that is, the first abutting surface 2324 is disposed at an acute angle with the top surface 2322 of the sliding end 232 of the first rotating member 23.

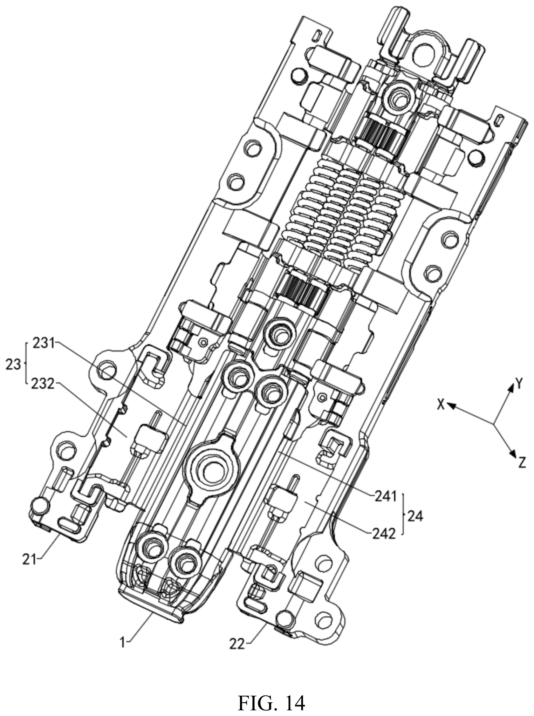

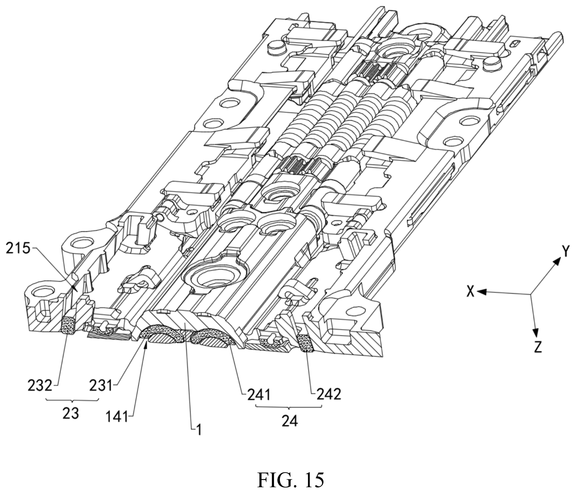

FIG. 14 is a diagram 1 of a partial structure of the folding mechanism 100 shown in FIG. 7 according to an implementation. FIG. 15 is a partially sectional view of the folding mechanism 100 shown in FIG. 7 at a D-D line according to an implementation.

As shown in FIG. 14 and FIG. 15, the rotating end 231 of the first rotating member 23 is rotatably connected to the main shaft 1. The sliding end 232 of the first rotating member 23 is slidably connected to the first fastening bracket 21. In another implementation, a manner in which the first rotating member 23 is connected to the main shaft 1 and the first fastening bracket 21 is not specifically limited.

For example, the rotating end 231 of the first rotating member 23 may be located in the arc-shaped groove 141 of the main shaft 1. The rotating end 231 of the first rotating member 23 may rotate in the arc-shaped groove 141 of the main shaft 1. It may be understood that when the rotating end 231 of the first rotating member 23 is connected to the main shaft 1 via a virtual shaft, a rotatable connection structure is simple, and a small space is occupied. This helps reduce a thickness of the folding mechanism 100, so that the folding mechanism 100 and the electronic device 1000 are more likely to be light and thin. In some other embodiments, the rotating end 231 of the first rotating member 23 may alternatively be connected to the main shaft 1 via a real shaft. This is not strictly limited in embodiments of this application.

For example, at least a part of the sliding end 232 of the first rotating member 23 may be located in the first sliding space 216 of the first fastening bracket 21. The sliding end 232 of the first rotating member 23 may slide in the first sliding space 216 of the first fastening bracket 21.

As shown in FIG. 13 to FIG. 15, the second rotating member 24 includes a rotating end 241 and a sliding end 242. The rotating end 241 of the second rotating member 24 is rotatably connected to the main shaft 1. The sliding end 242 of the second rotating member 24 is slidably connected to the second fastening bracket 22. It may be understood that the second rotating member 24 and the first rotating member 23 may be of a same structure, a symmetrical structure, a partially symmetrical structure, or different structures. This is not strictly limited in this application. For example, the second rotating member 24 and the first rotating member 23 may be of a symmetrical structure. For a basic design of a part structure of the second rotating member 24, a design of a connection relationship between parts, and a design of a connection relationship between a part and another structure outside the component, refer to a related solution of the first rotating member 23. For example, the second rotating member 24 and the first rotating member 23 are also allowed to be slightly different in detailed structures or position arrangement of parts.

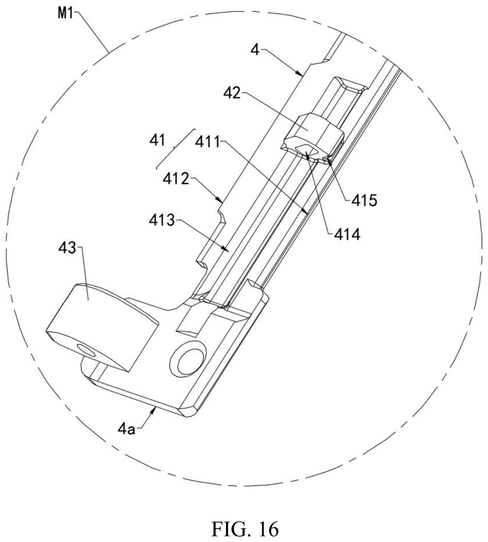

FIG. 16 is an enlarged diagram of the first support plate 4 shown in FIG. 8 at M1 according to an implementation.

As shown in FIG. 16, the first support plate 4 includes a first support plate body 41, a first movable block 42, and a first rotating block 43.

For example, the first support plate body 41 has a first fastening surface 413. The first fastening surface 413 and the second support surface 4a are disposed back to back. In addition, the first support plate body 41 further includes a right side surface 411 (also referred to as a first side surface 411) and a left side surface 412 (also referred to as a second side surface 412).

For example, the first movable block 42 protrudes from the first fastening surface 413. The first movable block 42 has a first inclined hole 414. In this case, the first movable block 42 is approximately in a ring shape. An outer ring surface of the first movable block 42 includes a second abutting surface 415. The second abutting surface 415 is a part of a surface that is of the outer ring surface of the first movable block 42 and that faces the right side surface 411 of the first support plate body 41.

For example, the second abutting surface 415 is disposed closer to the right side surface 411 of the first support plate body 41 than to the left side surface 412 of the first support plate body 41.

For example, the second abutting surface 415 is inclined to a direction of the right side surface 411 of the first support plate body 41. In this case, the second abutting surface 415 is disposed at an acute angle with the first fastening surface 413.

For example, the first rotating block 43 protrudes from the first fastening surface 413. The first rotating block 43 may be approximately in an arc shape. It may be understood that the first movable block 42 and the first rotating block 43 of the first support plate 4 may jointly form a connection structure. The first support plate 4 may include a plurality of connection structures that are spaced.

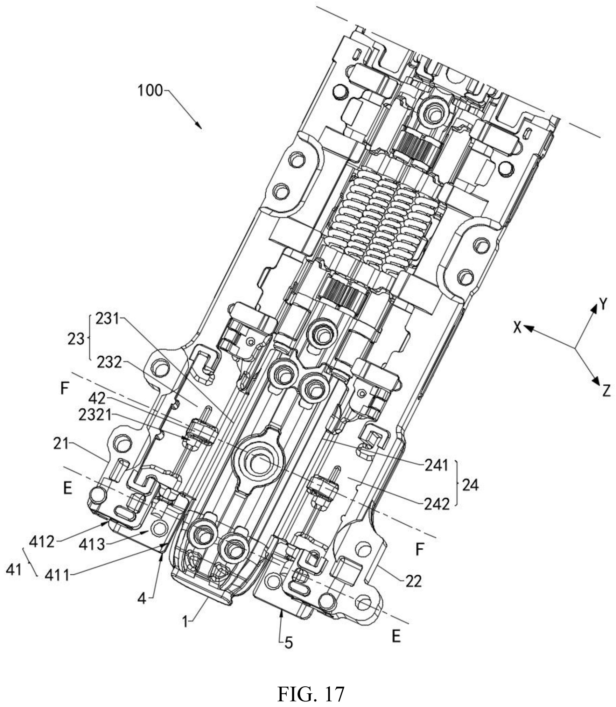

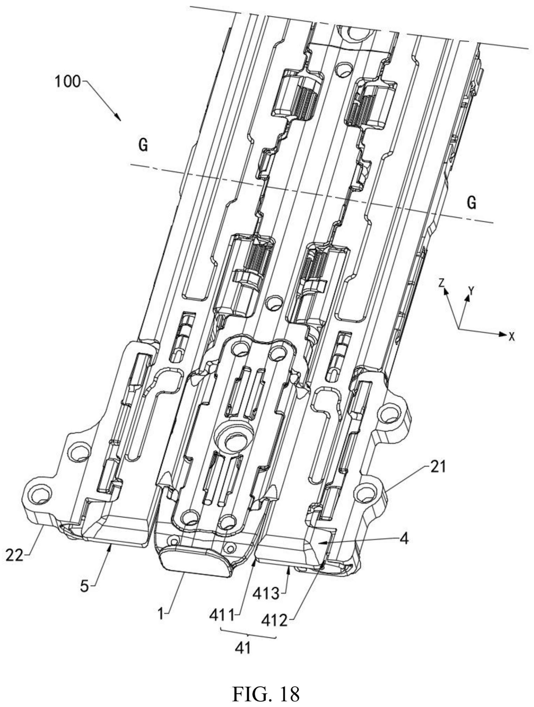

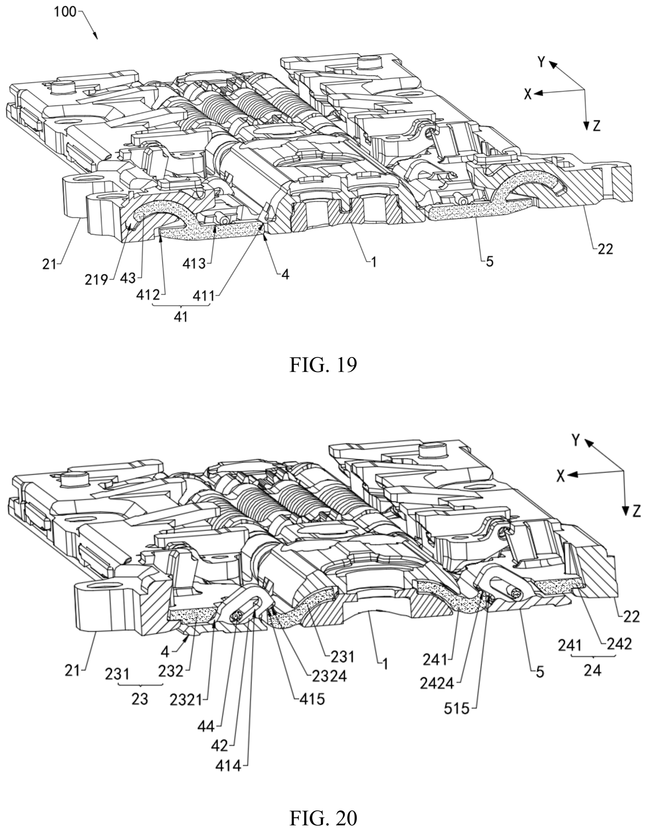

FIG. 17 is a diagram 2 of a partial structure of the folding mechanism 100 shown in FIG. 7 according to an implementation. FIG. 18 is a diagram of a structure of the folding mechanism 100 shown in FIG. 17 from another angle. FIG. 19 is a partially sectional view of the folding mechanism 100 shown in FIG. 17 at an E-E line according to an implementation.

As shown in FIG. 17 to FIG. 19, the main shaft 1 is located between the first support plate 4 and the second support plate 5. The right side surface 411 of the first support plate body 41 is disposed facing the main shaft 1 relative to the left side surface 412 of the first support plate body 41.

For example, the first support plate 4 is further rotatably connected to the first fastening bracket 21. For example, the first rotating block 43 of the first support plate 4 may be located in the arc-shaped space 219 of the first fastening bracket 21, and the first rotating block 43 of the first support plate 4 may rotate in the arc-shaped space 219 of the first fastening bracket 21. It may be understood that when the first support plate 4 is connected to the first fastening bracket 21 via a virtual shaft, a rotatable connection structure is simple, and a small space is occupied. This helps reduce the thickness of the folding mechanism 100, so that the folding mechanism 100 and the electronic device 1000 are more likely to be light and thin. In some other embodiments, the first support plate 4 may alternatively be connected to the first fastening bracket 21 via a real shaft. This is not strictly limited in embodiments of this application. In another implementation, a manner in which the first support plate 4 is connected to the first fastening bracket 21 is not specifically limited.

For example, a part of the first fastening bracket 21 is located on a side close to the first fastening surface 413 of the first support plate body 41, and a part of the first fastening bracket 21 is located on a side close to the left side surface 412 of the first support plate body 41. In this case, the first fastening surface 413 of the first support plate body 41 faces the first fastening bracket 21.

FIG. 20 is a partially sectional view of the folding mechanism 100 shown in FIG. 17 at an F-F line according to an implementation.

As shown in FIG. 17 and FIG. 20, for example, the first support plate 4 is slidably connected to the sliding end 232 of the first rotating member 23, and the first support plate 4 may rotate relative to the sliding end 232 of the first rotating member 23. In this case, the first support plate 4 is connected to the main shaft 1 via the first rotating member 23. For example, the first movable block 42 of the first support plate 4 passes through the first avoidance hole 2321 of the sliding end 232 of the first rotating member 23. The sliding end 232 of the first rotating member 23 may be slidably connected to the first movable block 42 of the first support plate 4 via a pin shaft 44. In addition, the sliding end 232 of the first rotating member 23 may rotate relative to the first movable block 42 of the first support plate 4 via the pin shaft 44. Specifically, the folding mechanism 100 includes the pin shaft 44. Two ends of the pin shaft 44 are fastened to the sliding end 232 of the first rotating member 23. A middle part of the pin shaft 44 passes through the first inclined hole 414 of the first movable block 42 of the first support plate 4. The middle part of the pin shaft 44 can slide in the first inclined hole 414 of the first support plate 4 and rotate relative to the first inclined hole 414. In another implementation, a manner in which the first support plate 4 is connected to the first rotating member 23 is not specifically limited.

As shown in FIG. 17 to FIG. 20, the second support plate 5 is rotatably connected to the second fastening bracket 22. The second support plate 5 is slidably connected to the sliding end 242 of the second rotating member 24, and the second support plate 5 may rotate relative to the sliding end 242 of the second rotating member 24. It may be understood that the second support plate 5 and the first support plate 4 may be of a same structure, a mirror-symmetrical structure, a partially mirror-symmetrical structure, a centrosymmetrical structure, a partially centrosymmetrical structure, or different structures. This is not strictly limited in this application. In some embodiments, the second support plate 5 and the first support plate 4 are of a symmetrical structure. For a basic design of a part structure of the second support plate 5, a design of a connection relationship between parts, and a design of a connection relationship between a part and another structure outside the component, refer to a related solution of the first support plate 4. In addition, the second support plate 5 and the first support plate 4 are allowed to be slightly different in detailed structures or position arrangement of parts. Details are not described herein again.

As shown in FIG. 17 to FIG. 20, the first fastening bracket 21 is fastened to the first housing 300 (refer to FIG. 6). The second fastening bracket 22 is fastened to the second housing 400 (refer to FIG. 6). For example, the first fastening bracket 21 may be connected to the first housing 300 by using screws. The second fastening bracket 22 may be connected to the second housing 400 by using screws. It may be understood that the first fastening bracket 21 is fastened to the first housing 300, the second fastening bracket 22 is fastened to the second housing 400, the first rotating member 23 is connected to the first fastening bracket 21 and the main shaft 1, and the second rotating member 24 is connected to the second fastening bracket 22 and the main shaft 1. Therefore, the first housing 300 may be connected to the second housing 400 via the first fastening bracket 21, the first rotating member 23, the second rotating member 24, and the second fastening bracket 22. In this way, when the electronic device 1000 switches from the unfolded state to the folded state, the first housing 300 and the second housing 400 approach each other, the first housing 300 can drive, via the first rotating member 23, the first fastening bracket 21 to rotate relative to the main shaft 1, and the second housing 400 can drive, via the second rotating member 24, the second fastening bracket 22 to rotate relative to the main shaft 1. When the electronic device 1000 switches from the folded state to the unfolded state, the first housing 300 and the second housing 400 are unfolded relative to each other, the first housing 300 can drive, via the first rotating member 23, the first fastening bracket 21 to rotate relative to the main shaft 1, and the second housing 400 can drive, via the second rotating member 24, the second fastening bracket 22 to rotate relative to the main shaft 1.

It may be understood that, as shown in FIG. 14 and FIG. 15, the sliding end 232 of the first rotating member 23 is slidably connected to the first fastening bracket 21, the rotating end 231 of the first rotating member 23 is rotatably connected to the main shaft 1 (for example, the first rotating member 23 and the main shaft 1 are constrained via a virtual shaft), the sliding end 242 of the second rotating member 24 is slidably connected to the second fastening bracket 22, and the rotating end 241 of the second rotating member 24 is rotatably connected to the main shaft 1 (for example, the second rotating member 24 and the main shaft 1 are constrained via a virtual shaft). Therefore, in a process in which the first housing 300 and the second housing 400 are unfolded or folded relative to each other, a relative movement trajectory between the first fastening bracket 21 and the main shaft 1 can be determined, and a relative movement trajectory between the second fastening bracket 22 and the main shaft 1 can be determined. As shown in FIG. 16 to FIG. 20, the first support plate 4 is rotatably connected to the first fastening bracket 21 (for example, the first support plate 4 and the first fastening bracket 21 are constrained and limited via a virtual shaft), and the first support plate 4 is slidably connected to the first rotating member 23 and rotates relative to the first rotating member 23. Therefore, a movement trajectory of the first support plate 4 is restricted by the first fastening bracket 21 and the first rotating member 23. The second support plate 5 is rotatably connected to the second fastening bracket 22 (for example, the second support plate 5 and the second fastening bracket 22 are constrained and limited via a virtual shaft), and the second support plate 5 is slidably connected to the second rotating member 24 and rotates relative to the second rotating member 24. Therefore, a movement trajectory of the second support plate 5 is restricted by the second fastening bracket 22 and the second rotating member 24. When movement trajectories of the first fastening bracket 21 and the second fastening bracket 22 relative to the main shaft 1 are determined, the movement trajectories of the first support plate 4 and the second support plate 5 can also be determined.

It may be understood that the first support plate 4 fits with the first rotating member 23 via the pin shaft 44 and the first inclined hole 414, to control an unfolding or folding angle of the first support plate 4.

As shown in FIG. 20, when the electronic device 1000 is in the unfolded state, the first abutting surface 2324 of the first rotating member 23 abuts against the second abutting surface 415 of the first support plate 4. The first abutting surface 2324 of the first rotating member 23 and the second abutting surface 415 of the first support plate 4 form a lap joint surface. The first abutting surface 2324 of the first rotating member 23 may be in interference fit with the second abutting surface 415 of the first support plate 4, so that the first support plate 4 generates acting force in a movement direction. In this way, because there is a magnitude of interference set between the first abutting surface 2324 of the first rotating member 23 and the second abutting surface 415 of the first support plate 4, acting force can be generated between the first abutting surface 2324 of the first rotating member 23 and the second abutting surface 415 of the first support plate 4. Therefore, the acting force is used to control the angle between the first support plate 4 and the main shaft 1, that is, control a form of the first support plate 4 in the unfolded state of the electronic device 1000. For example, the acting force between the first abutting surface 2324 of the first rotating member 23 and the second abutting surface 415 of the first support plate 4 may cause the angle between the first support plate 4 and the main shaft 1 to be equal to 180° as much as possible, that is, it is ensured as much as possible that the flexible display 200 is completely unfolded. In this way, the flexible display 200 has good appearance consistency, to meet user experience.

It may be understood that, for different folding mechanisms 100, angles between first support plates 4 and main shafts 1 deviate from 180° by different amplitudes when the electronic device 1000 is in the unfolded state. In this case, the angle between the first support plate 4 and the main shaft 1 can be adjusted to different degrees by adjusting the magnitude of the interference between the first abutting surface 2324 of the first rotating member 23 and the second abutting surface 415 of the first support plate 4 to different degrees, to better control the form of the first support plate 4 in the unfolded state of the electronic device 1000. For example, for some folding mechanisms 100, when the electronic device 1000 is in the unfolded state, the angle between the first support plate 4 and the main shaft 1 is 190° that deviates from 180° by a large amplitude. In this case, the magnitude of the interference between the first abutting surface 2324 of the first rotating member 23 and the second abutting surface 415 of the first support plate 4 can be greatly increased, to adjust the angle between the first support plate 4 and the main shaft 1 in the unfolded state of the electronic device 1000 to a large degree, so that the angle between the first support plate 4 and the main shaft 1 can be 180°. For some folding mechanisms 100, when the electronic device 1000 is in the unfolded state, the angle between the first support plate 4 and the main shaft 1 is 185° that deviates from 180° by a small amplitude. In this case, the magnitude of the interference between the first abutting surface 2324 of the first rotating member 23 and the second abutting surface 415 of the first support plate 4 can be slightly increased, to slightly adjust the angle between the first support plate 4 and the main shaft 1, so that the angle between the first support plate 4 and the main shaft 1 can be 180°.

In this implementation, the second abutting surface 415 is a part of a surface that is of the outer ring surface of the first movable block 42 and that is close to the right side surface 411. In this case, the second abutting surface 415 is disposed close to the main shaft 1. The lap joint surface formed by the first abutting surface 2324 of the first rotating member 23 and the second abutting surface 415 of the first support plate 4 is disposed closer to the main shaft 1. In this way, the angle between the first support plate 4 and the main shaft 1 can be adjusted to a large degree by slightly increasing the magnitude of the interference between the first abutting surface 2324 of the first rotating member 23 and the second abutting surface 415 of the first support plate 4, so that the form between the first support plate 4 and the main shaft 1 in the unfolded state of the electronic device 1000 can be better controlled, and precision of adjusting the angle between the first support plate 4 and the main shaft 1 in the unfolded state of the electronic device 1000 is also high. For example, when the lap joint surface formed by the first abutting surface 2324 of the first rotating member 23 and the second abutting surface 415 of the first support plate 4 is far away from the main shaft 1, the magnitude of the interference between the first abutting surface 2324 of the first rotating member 23 and the second abutting surface 415 of the first support plate 4 needs to be set to 0.5 millimeters, so that the angle between the first support plate 4 and the main shaft 1 is 180°. When the lap joint surface formed by the first abutting surface 2324 of the first rotating member 23 and the second abutting surface 415 of the first support plate 4 is close to the main shaft 1, the magnitude of the interference between the first abutting surface 2324 of the first rotating member 23 and the second abutting surface 415 of the first support plate 4 is set to 0.2 millimeters, so that the angle between the first support plate 4 and the main shaft 1 is 180°.

In this implementation, the first abutting surface 2324 is disposed to be inclined to the direction of the rotating end 231 of the first rotating member 23, and the second abutting surface 415 is inclined to the direction of the right side surface 411 of the first support plate body 41, so that the lap joint surface formed by the first abutting surface 2324 of the first rotating member 23 and the second abutting surface 415 of the first support plate 4 is disposed in an inclined manner. In this way, when the first abutting surface 2324 of the first rotating member 23 is in interference fit with the second abutting surface 415 of the first support plate 4 when the electronic device 1000 is in the unfolded state, acting force between the first abutting surface 2324 of the first rotating member 23 and the second abutting surface 415 of the first support plate 4 has greater acting force in a movement direction (for example, component force in a Z-axis direction is greater), so that the angle between the first support plate 4 and the main shaft 1 in the unfolded state of the electronic device 1000 can be better controlled, and the form between the first support plate 4 and the main shaft 1 in the unfolded state of the electronic device 1000 can be better controlled.

The foregoing specifically describes a fitting relationship between the first rotating member 23 and the first support plate 4 with reference to related accompanying drawings. For a fitting relationship between the second rotating member 24 and the second support plate 5, refer to the fitting relationship between the first rotating member 23 and the first support plate 4 (for example, the second rotating member 24 includes a third abutting surface 2424, the second support plate 5 further includes a fourth abutting surface 515, and the third abutting surface 2424 is in interference fit with the fourth abutting surface 515). Details are not described herein again. In this way, when the electronic device 1000 is in the unfolded state, the angle between the first support plate 4 and the main shaft 1 is equal to 180° as much as possible, and the angle between the second support plate 5 and the main shaft 1 can also be equal to 180° as much as possible, to ensure, to a large degree, that the flexible display 200 is completely unfolded. In this way, the flexible display 200 has better appearance consistency, to meet user experience.

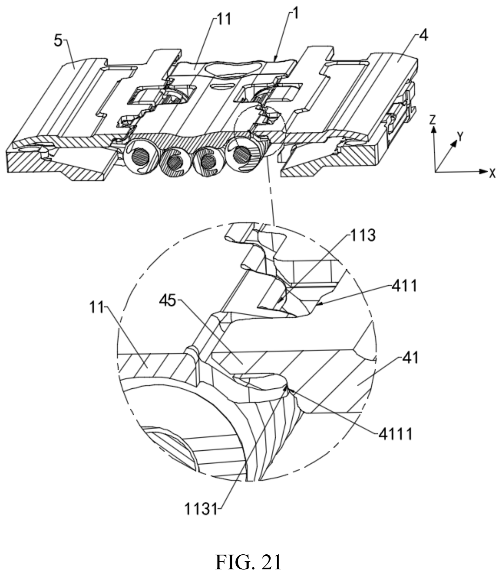

FIG. 21 is a partially sectional view of the folding mechanism 100 shown in FIG. 18 at a G-G line according to an implementation.

As shown in FIG. 21, a side surface 113 of the base 11 includes a first contact surface 1131. The right side surface 411 of the first support plate 4 includes a second contact surface 4111.

When the electronic device 1000 is in the unfolded state, the first contact surface 1131 abuts against the second contact surface 4111. In this way, the base 11 can prevent the first support plate 4 from continuing to rotate relative to the base 11, to assist in controlling the angle between the first support plate 4 and the main shaft 1, so as to prevent the first support plate 4 from forming a "V"-shaped included angle due to overfolding, that is, so as to control the angle between the first support plate 4 and the main shaft 1 to be 180° as much as possible.

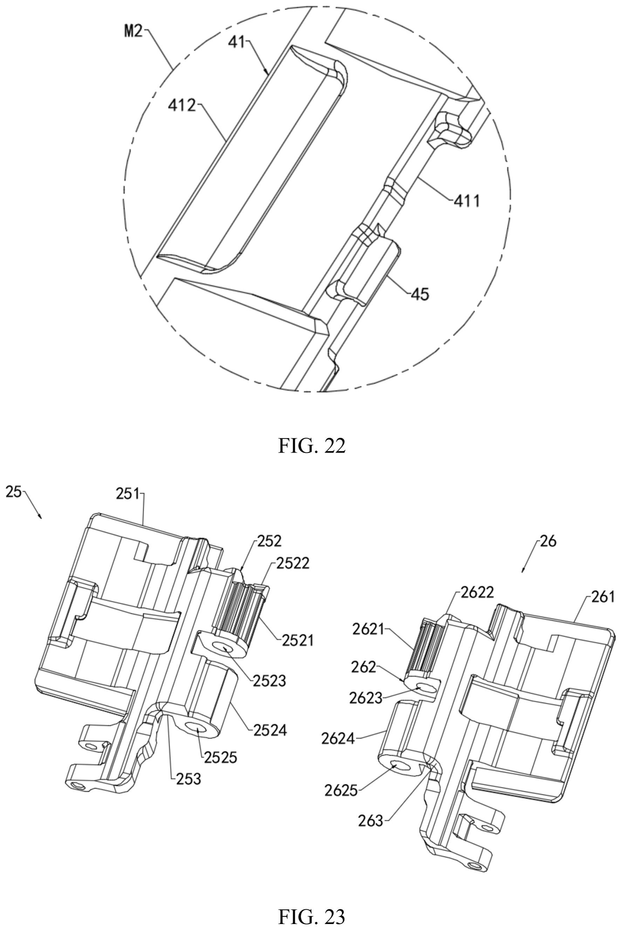

FIG. 22 is an enlarged diagram of the first support plate 4 shown in FIG. 8 at M2 according to an implementation.

As shown in FIG. 21 and FIG. 22, the first support plate 4 has a first extension block 45. The first extension block 45 protrudes from the right side surface 411 of the first support plate body 41.

As shown in FIG. 21 and FIG. 22, when the electronic device 1000 is in the unfolded state, the first extension block 45 of the first support plate 4 is disposed opposite to a part of the base 11. In this way, when the electronic device 1000 falls, the first extension block 45 can block the first support plate 4, to prevent the first support plate 4 from continuing to fall.

For example, the first extension block 45 of the first support plate 4 is not in contact with the base 11. In this way, in a process of unfolding or folding the electronic device 1000, the first extension block 45 of the first support plate 4 and the base 11 do not easily interfere with each other.

It may be understood that, for a fitting relationship between the second support plate 5 and the main shaft 1, refer to the fitting relationship between the first support plate 4 and the main shaft 1. Details are not described herein again. In this way, the second support plate 5 fits with the main shaft 1, to assist in controlling the angle between the second support plate 5 and the main shaft 1 in the unfolded state of the electronic device 1000, so as to prevent the second support plate 5 from forming a "V"-shaped included angle due to overfolding.

FIG. 23 is a diagram of structures of the first large gear connecting rod 25 and the first small gear connecting rod 27a shown in FIG. 11 according to an implementation.

As shown in FIG. 23, the first large gear connecting rod 25 includes a sliding end 251 and a rotating end 252.

For example, the sliding end 251 of the first large gear connecting rod 25 is approximately in a plate shape. The rotating end 252 of the first large gear connecting rod 25 includes a first gear part 2521 and a plurality of first protrusions 2522. A rotating shaft hole 2523 may be disposed on the first gear part 2521, the plurality of first protrusions 2522 are located at an end of the first gear part 2521, the plurality of first protrusions 2522 are arranged in a ring shape and spaced from each other, and the plurality of first protrusions 2522 are disposed around the rotating shaft hole 2523 of the first gear part 2521. The first large gear connecting rod 25 may be an integrally formed structural member, to have high structural strength.

For example, the rotating end 252 of the first large gear connecting rod 25 further includes a first rotating shaft part 2524. The first rotating shaft part 2524 is located on a side that is of the first gear part 2521 and that is away from the first protrusion 2522. The first rotating shaft part 2524 and the first gear part 2521 are spaced. A rotating hole 2525 may be disposed on the first rotating shaft part 2524. The rotating hole 2525 of the first rotating shaft part 2524 is disposed opposite to the rotating shaft hole 2523 of the first gear part 2521.

For example, the first large gear connecting rod 25 may further include a connecting section 253 connecting the sliding end 251 and the rotating end 252, and the connecting section 253 may be bent relative to the sliding end 251 of the first large gear connecting rod 25, so that a shape of the first large gear connecting rod 25 is more diversified.

As shown in FIG. 23, the second large gear connecting rod 26 includes a sliding end 261 and a rotating end 262.

For example, the sliding end 261 of the second large gear connecting rod 26 is approximately in a plate shape. The rotating end 262 of the second large gear connecting rod 26 includes a second gear part 2621 and a plurality of second protrusions 2622. A rotating shaft hole 2623 may be disposed on the second gear part 2621, the plurality of second protrusions 2622 are located at an end of the second gear part 2621, the plurality of second protrusions 2622 are arranged in a ring shape and spaced from each other, and the plurality of second protrusions 2622 are disposed around the rotating shaft hole 2623 of the second gear part 2621. The second large gear connecting rod 26 may be an integrally formed structural member, to have high structural strength.

For example, the rotating end 262 of the second large gear connecting rod 26 further includes a second rotating shaft part 2624. The second rotating shaft part 2624 is located on a side that is of the second gear part 2621 and that is away from the second protrusion 2622. The second rotating shaft part 2624 and the second gear part 2621 are spaced. A rotating hole 2625 may be disposed on the second rotating shaft part 2624. The rotating hole 2625 of the second rotating shaft part 2624 is disposed opposite to the rotating shaft hole 2623 of the second gear part 2621.

For example, the second large gear connecting rod 26 may further include a connecting section 263 connecting the sliding end 261 and the rotating end 262, and the connecting section 263 may be bent relative to the sliding end 261 of the second large gear connecting rod 26, so that a shape of the second large gear connecting rod 26 is more diversified.

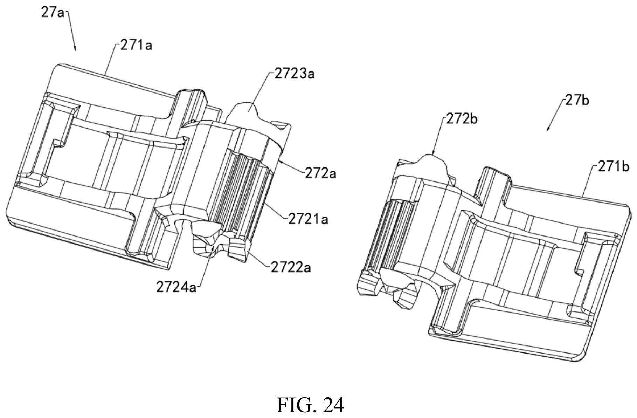

FIG. 24 is a diagram of structures of the first small gear connecting rod 27a and the second small gear connecting rod 27b shown in FIG. 11 according to an implementation.

As shown in FIG. 24, the first small gear connecting rod 27a includes a sliding end 271a and a rotating end 272a.

For example, the sliding end 271a of the first small gear connecting rod 27a is approximately in a plate shape. The rotating end 272a of the first small gear connecting rod 27a includes a gear part 2721a, a plurality of first protrusion parts 2722a, and a plurality of second protrusion parts 2723a. A rotating shaft hole 2724a may be disposed on the gear part 2721a. The plurality of first protrusion parts 2722a and the plurality of second protrusion parts 2723a are disposed back to back at two ends of the gear part 2721a. The plurality of first protrusion parts 2722a are arranged in a ring shape and spaced from each other, and the plurality of first protrusion parts 2722a are disposed around the rotating shaft hole 2523 of the gear part. The plurality of second protrusion parts 2723a are arranged in a ring shape and spaced from each other, and the plurality of second protrusion parts 2723a are disposed around the rotating shaft hole 2523 of the gear part. The first small gear connecting rod 27a may be an integrally formed structural member, to have high structural strength.

As shown in FIG. 24, the second small gear connecting rod 27b includes a sliding end 271b and a rotating end 272b. It may be understood that the second small gear connecting rod 27b and the first small gear connecting rod 27a may be of a same structure, a symmetrical structure, a partially symmetrical structure, or different structures. This is not strictly limited in this application. For example, the second small gear connecting rod 27b and the first small gear connecting rod 27a may be of a symmetrical structure. For a basic design of a part structure of the second small gear connecting rod 27b, a design of a connection relationship between parts, and a design of a connection relationship between a part and another structure outside the component, refer to a related solution of the first small gear connecting rod 27a. In addition, the second small gear connecting rod 27b and the first small gear connecting rod 27a are allowed to be slightly different in detailed structures or position arrangement of parts. Details are not described herein again.

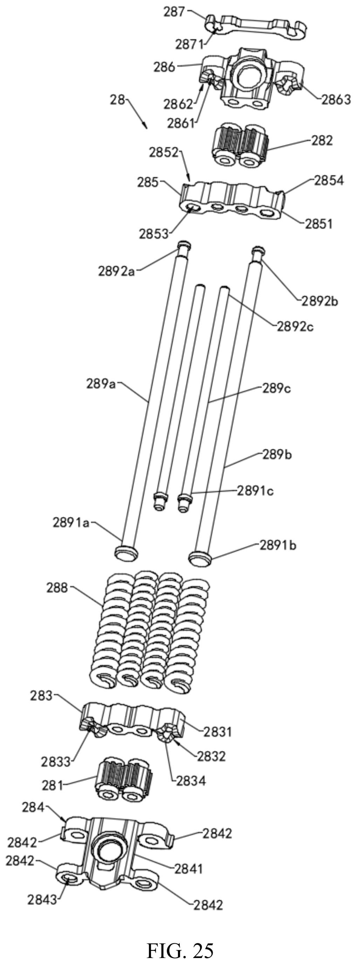

FIG. 25 is a partially exploded view of the damping member 28 shown in FIG. 11 according to an implementation.

As shown in FIG. 25, the damping member 28 includes a first synchronization gear 281, a second synchronization gear 282, a first clamping member 283, a second clamping member 284, a third clamping member 285, a fourth clamping member 286, a fastening plate 287, a first elastic member 288, a first rotatable connecting shaft 289a, a second rotatable connecting shaft 289b, and a third rotatable connecting shaft 289c.

For example, there may be a plurality of first synchronization gears 281, and the plurality of first synchronization gears 281 are meshed with each other. For example, the plurality of first synchronization gears 281 may be arranged in a string.

For example, there may be a plurality of second synchronization gears 282, and the plurality of second synchronization gears 282 are meshed with each other. For example, the plurality of second synchronization gears 282 may be arranged in a string.

In some embodiments, the first clamping member 283 is located between the first elastic member 288 and the first synchronization gear 281. The second clamping member 284 is located on a side that is of the first synchronization gear 281 and that is away from the first clamping member 283. The second synchronization gear 282 is located on a side that is of the first elastic member 288 and that is away from the first clamping member 283. The third clamping member 285 is located between the first elastic member 288 and the second synchronization gear 282. The fourth clamping member 286 is located on a side that is of the second synchronization gear 282 and that is away from the third clamping member 285. The fastening plate 287 is located on a side that is of the fourth clamping member 286 and that is away from the second synchronization gear 282. For example, the second clamping member 284, the first synchronization gear 281, the first clamping member 283, the first elastic member 288, the third clamping member 285, the second synchronization gear 282, the fourth clamping member 286, and the fastening plate 287 are sequentially arranged in the length extension direction parallel to the main shaft 1.

As shown in FIG. 25, for example, the first clamping member 283 includes a first clamping plate 2831 and a plurality of first bump groups 2832, and the plurality of first bump groups 2832 are fastened to a surface of a same side of the first clamping plate 2831. The first clamping plate 2831 includes a plurality of first through holes 2833, and the plurality of first through holes 2833 are spaced from each other. Two first bump groups 2832 are disposed in a one-to-one correspondence with two first through holes 2833. Each first bump group 2832 may include a plurality of first bumps 2834, the plurality of first bumps 2834 are arranged in a ring shape and spaced from each other, the plurality of first bumps 2834 are disposed around the first through hole 2833, and a clamping groove is formed between two adjacent first bumps 2834. The first clamping member 283 may be an integrally formed structural member, to have high structural strength.

As shown in FIG. 25, for example, the second clamping member 284 includes a main body part 2841 and a plurality of rotating shaft blocks 2842. There may be four rotating shaft blocks 2842. Two rotating shaft blocks 2842 are located on one side of the main body part 2841 and are spaced. The other two rotating shaft blocks 2842 are located on the other side of the main body part 2841 and are spaced. A second through hole 2843 is disposed on each rotating shaft block 2842. Second through holes 2843 of rotating shaft blocks 2842 on a same side are disposed opposite to each other.

As shown in FIG. 25, for example, the third clamping member 285 includes a third clamping plate 2851 and a plurality of second bump groups 2852, and the plurality of second bump groups 2852 are fastened to a surface of a same side of the third clamping plate 2851. The third clamping plate 2851 includes a plurality of third through holes 2853, and the plurality of third through holes 2853 are spaced from each other. Two second bump groups 2852 are disposed in a one-to-one correspondence with two third through holes 2853. Each second bump group 2852 may include a plurality of second bumps 2854, the plurality of second bumps 2854 are arranged in a ring shape and spaced from each other, the plurality of second bumps 2854 are disposed around the third through hole 2853, and a clamping groove is formed between two adjacent second bumps 2854. The third clamping member 285 may be an integrally formed structural member, to have high structural strength.

As shown in FIG. 25, for example, the fourth clamping member 286 includes a plurality of fourth through holes 2861 and a plurality of third bump groups 2862, and the plurality of fourth through holes 2861 are spaced from each other. Two third bump groups 2862 are disposed in a one-to-one correspondence with two fourth through holes 2861. Each third bump group 2862 may include a plurality of third bumps 2863, the plurality of third bumps 2863 are arranged in a ring shape and spaced from each other, the plurality of third bumps 2863 are disposed around the fourth through hole 2861, and a clamping groove is formed between two adjacent third bumps 2863. The fourth clamping member 286 may be an integrally formed structural member, to have high structural strength.

As shown in FIG. 25, for example, the fastening plate 287 may be of a plate structure. The fastening plate 287 includes a plurality of fifth through holes 2871, and the plurality of fifth through holes 2871 are spaced from each other. For example, arrangement shapes and arrangement spacings of the plurality of first through holes 2833, the plurality of second through holes 2843, the plurality of third through holes 2853, the plurality of fourth through holes 2861, and the plurality of fifth through holes 2871 may be the same.

As shown in FIG. 25, for example, the first elastic member 288 includes a plurality of springs.

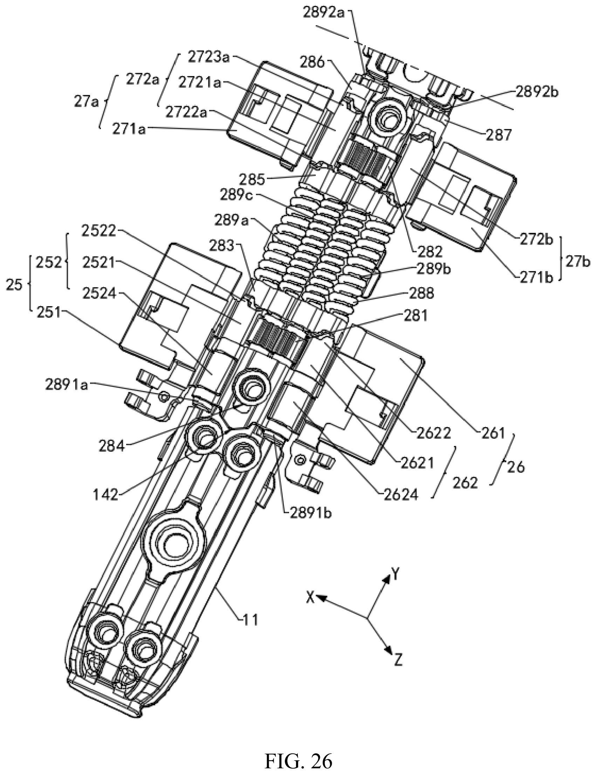

FIG. 26 is a diagram 3 of a partial structure of the folding mechanism 100 shown in FIG. 7 according to an implementation.

As shown in FIG. 25 and FIG. 26 and with reference to FIG. 23 and FIG. 24, the first rotatable connecting shaft 289a is inserted into the second clamping member 284, the rotating end 252 of the first large gear connecting rod 25, the first clamping member 283, a first elastic member 288, the third clamping member 285, the rotating end 272a of the first small gear connecting rod 27a, the fourth clamping member 286, and the fastening plate 287. The first rotatable connecting shaft 289a passes through a second through hole 2843 of the second clamping member 284, the rotating hole 2525 and the rotating shaft hole 2523 of the first large gear connecting rod 25, a first through hole 2833 of the first clamping member 283, an inner space of the first elastic member 288, a third through hole 2853 of the third clamping member 285, the rotating shaft hole 2724a of the first small gear connecting rod 27a, a fourth through hole 2861 of the fourth clamping member 286, and a fifth through hole 2871 of the fastening plate 287.

The first rotatable connecting shaft 289a includes a first end part 2891a and a second end part 2892a that are disposed back to back, the first end part 2891a of the first rotatable connecting shaft 289a is close to the second clamping member 284 and protrudes relative to the second clamping member 284, and the second end part 2892a of the first rotatable connecting shaft 289a is close to the fastening plate 287 and protrudes relative to the fastening plate 287. For example, a limiting flange may be disposed at the first end part 2891a of the first rotatable connecting shaft 289a, the limiting flange is located on a side that is of the second clamping member 284 and that is away from the first clamping member 283, and the limiting flange may abut against the second clamping member 284 to implement limiting. The second end part 2892a of the first rotatable connecting shaft 289a may be fastened to the fastening plate 287 through welding, bonding, or the like. The spring is in a compressed state.

In some embodiments, a quantity of third rotatable connecting shaft 289c, a quantity of first synchronization gears 281, and a quantity of second synchronization gears 282 are the same, and the third rotatable connecting shaft 289c, the first synchronization gear 281, the second synchronization gear 282, and some of the plurality of first elastic members 288 are disposed in a one-to-one correspondence. The third rotatable connecting shaft 289c is inserted into the second clamping member 284, the first synchronization gear 281, the first clamping member 283, another first elastic member 288, the third clamping member 285, the second synchronization gear 282, the fourth clamping member 286, and the fastening plate 287. The third rotatable connecting shaft 289c passes through a rotating shaft hole of the first synchronization gear 281, another first through hole 2833 of the first clamping member 283, an inner space of the another first elastic member 288, another third through hole 2853 of the third clamping member 285, and a rotating shaft hole of the second synchronization gear 282 in sequence. The third rotatable connecting shaft 289c includes a first end part 2891c and a second end part 2892c that are disposed opposite back to back, and the first end part 2891c of the third rotatable connecting shaft 289c is inserted into another second through hole 2843 of the second clamping member 284 and abuts against a hole wall of the second through hole 2843, to implement limiting. The second end part 2892c of the third rotatable connecting shaft 289c is inserted into another fourth through hole 2861 of the fourth clamping member 286 and abuts against a hole wall of the fourth through hole 2861, to implement limiting.

In some embodiments, the second rotatable connecting shaft 289b is inserted into the second clamping member 284, the rotating end 262 of the second large gear connecting rod 26, the first clamping member 283, another spring, the third clamping member 285, the second synchronization gear 282, the fourth clamping member 286, and the fastening plate 287. The second rotatable connecting shaft 289b passes through another second through hole 2843 of the second clamping member 284, the rotating shaft hole 2623 of the second large gear connecting rod 26, another first through hole 2833 of the first clamping member 283, an inner space of another first elastic member 288, another third through hole 2853 of the third clamping member 285, a rotating shaft hole of the second small gear connecting rod 27b, another fourth through hole 2861 of the fourth clamping member 286, and another fifth through hole 2871 of the fastening plate 287.

The second rotatable connecting shaft 289b includes a first end part 2891b and a second end part 2892b that are disposed back to back, the first end part 2891b of the second rotatable connecting shaft 289b is close to the second clamping member 284 and protrudes relative to the second clamping member 284, and the second end part 2892b of the second rotatable connecting shaft 289b is close to the fastening plate 287 and protrudes relative to the fastening plate 287. For example, a limiting flange may be disposed at the first end part 2891b of the second rotatable connecting shaft 289b, the limiting flange is located on the side that is of the second clamping member 284 and that is away from the first clamping member 283, and the limiting flange may abut against the second clamping member 284 to implement limiting. The second end part 2892b of the second rotatable connecting shaft 289b may be fastened to the fastening plate 287 through welding, bonding, or the like. The spring is in a compressed state.

As shown in FIG. 26 and with reference to FIG. 23, the rotating end 252 of the first large gear connecting rod 25 is meshed with the rotating end 262 of the second large gear connecting rod 26 via the plurality of first synchronization gears 281. It may be understood that the rotating end 252 of the first large gear connecting rod 25 is connected to the rotating end 262 of the second large gear connecting rod 26 via the plurality of first synchronization gears 281, so that a rotation angle of the rotating end 252 of the first large gear connecting rod 25 and a rotation angle of the rotating end 262 of the second large gear connecting rod 26 have a same size and opposite directions, and rotation actions of the first large gear connecting rod 25 and the second large gear connecting rod 26 are kept synchronous relative to the main shaft 1, that is, the first large gear connecting rod 25 and the second large gear connecting rod 26 are synchronously close to or away from each other.

As shown in FIG. 26 and with reference to FIG. 24, the rotating end 272a of the first small gear connecting rod 27a is meshed with the rotating end 272b of the second small gear connecting rod 27b via the plurality of second synchronization gears 282. It may be understood that the rotating end 272a of the first small gear connecting rod 27a is connected to the rotating end 272b of the second small gear connecting rod 27b via the plurality of second synchronization gears 282, so that a rotation angle of the rotating end 272a of the first small gear connecting rod 27a and a rotation angle of the rotating end 272b of the second small gear connecting rod 27b have a same size and opposite directions, and rotation actions of the first small gear connecting rod 27a and the second small gear connecting rod 27b are kept synchronous relative to the main shaft 1, that is, the first small gear connecting rod 27a and the second small gear connecting rod 27b are synchronously close to or away from each other.

As shown in FIG. 26, the first gear part 2521 of the rotating end 252 of the first large gear connecting rod 25 and the second gear part 2621 of the rotating end 262 of the second large gear connecting rod 26 are located between the first clamping member 283 and the second clamping member 284. The rotating end 272a of the first small gear connecting rod 27a and the rotating end 272b of the second small gear connecting rod 27b are located between the third clamping member 285 and the fourth clamping member 286.

Refer to FIG. 25 and FIG. 26. With reference to FIG. 23 and FIG. 24, the plurality of first protrusions 2522 of the first large gear connecting rod 25 and a plurality of first bumps 2834 of a first bump group 2832 are arranged in a staggered manner to form a clamping structure. The plurality of second protrusions 2622 of the second large gear connecting rod 26 and a plurality of first bumps 2834 of another first bump group 2832 are arranged in a staggered manner to form a clamping structure.

In some embodiments, both the rotating end 252 of the first large gear connecting rod 25 and the rotating end 262 of the second large gear connecting rod 26 are clamped to the first clamping member 283, to form a clamping structure, so that the first large gear connecting rod 25 and the second large gear connecting rod 26 can stay in some positions.

In addition, the first elastic member 288 is in the compressed state, and elastic force generated by the first elastic member 288 causes the first clamping member 283 to abut against the rotating end 252 of the first large gear connecting rod 25 and the rotating end 262 of the second large gear connecting rod 26. In this case, the first clamping member 283 and the second clamping member 284 fit to press the rotating end 252 of the first large gear connecting rod 25, the first synchronization gear 281, and the rotating end 262 of the second large gear connecting rod 26, so that a clamping structure between the rotating end 252 of the first large gear connecting rod 25, the first synchronization gear 281, the rotating end 262 of the second large gear connecting rod 26, the first clamping member 283, and the second clamping member 284 is stable.

When the rotating end 252 of the first large gear connecting rod 25, the rotating end 262 of the second large gear connecting rod 26, and the first synchronization gear 281 rotate relative to the first clamping member 283 and the second clamping member 284, relative positions of the plurality of first protrusions 2522 and a plurality of first bumps 2834 of a first bump group 2832 change, so that different clamping structures can be formed; and relative positions of the plurality of second protrusions and a plurality of first bumps 2834 of another first bump group 2832 change, so that different clamping structures can be formed.

In addition, the elastic force generated by the first elastic member 288 further causes the third clamping member 285 to abut against the rotating end 272a of the first small gear connecting rod 27a and the rotating end 272b of the second small gear connecting rod 27b. In this case, the third clamping member 285 and the fourth clamping member 286 fit to press the rotating end 272a of the first small gear connecting rod 27a, the second synchronization gear 282, and the rotating end 272b of the second small gear connecting rod 27b, so that a clamping structure between the rotating end 272a of the first small gear connecting rod 27a, the second synchronization gear 282, the rotating end 272b of the second small gear connecting rod 27b, the third clamping member 285, and the fourth clamping member 286 is stable.

In some embodiments, the plurality of first protrusion parts 2722a of the first small gear connecting rod 27a and the plurality of second bumps 2854 of the second bump group 2852 of the third clamping member 285 are arranged in a staggered manner to form a clamping structure. The plurality of second protrusion parts 2723a of the first small gear connecting rod 27a and the plurality of third bumps 2863 of the third bump group 2862 of the fourth clamping member 286 are arranged in a staggered manner to form a clamping structure. In addition, the second small gear connecting rod 27b may also form a clamping structure with both the third clamping member 285 and the fourth clamping member 286. For a movement relationship between the first small gear connecting rod 27a and the third clamping member 285 and the fourth clamping member 286, and a movement relationship between the second small gear connecting rod 27b and the third clamping member 285 and the fourth clamping member 286, refer to a movement relationship between the first large gear connecting rod 25 and the first clamping member 283. Details are not described again.

As shown in FIG. 26, the rotating end 252 of the first large gear connecting rod 25, the rotating end 262 of the second large gear connecting rod 26, the rotating end 272a of the first small gear connecting rod 27a, the rotating end 272b of the second small gear connecting rod 27b, and the damping member 28 are all mounted in the movable space 142 of the main shaft 1. The sliding end 251 of the first large gear connecting rod 25, the sliding end 261 of the second large gear connecting rod 26, the sliding end 271a of the first small gear connecting rod 27a, and the sliding end 271b of the second small gear connecting rod 27b are all located on an outer side of the main shaft 1.

For example, both the second clamping member 284 and the fourth clamping member 286 of the damping member 28 are fastened to the base 11 of the main shaft 1. For example, the second clamping member 284 and the fourth clamping member 286 may be locked on the main shaft 1 via a fastener (a screw, a pin, a rivet, or the like). In this way, another part of the damping member 28, the first large gear connecting rod 25, the second large gear connecting rod 26, the first small gear connecting rod 27a, and the second small gear connecting rod 27b can all be stably mounted on the main shaft 1, and are not likely to shake or detach from the main shaft 1, to improve the reliability of the folding mechanism 100. The rotating end 252 of the first large gear connecting rod 25 and the rotating end 272a of the first small gear connecting rod 27a are rotatably connected to the main shaft 1 via the first rotatable connecting shaft 289a. The first synchronization gear 281 and the second synchronization gear 282 are rotatably connected to the main shaft 1 via the third rotatable connecting shaft 289c. The rotating end 262 of the second large gear connecting rod 26 and the rotating end 272b of the second small gear connecting rod 27b are rotatably connected to the main shaft 1 via the second rotatable connecting shaft 289b.

It may be understood that the quantities, dimensions, and the like of the first synchronization gear 281 and the second synchronization gear 282 may be designed based on a specific product form, a dimension, and the like. This is not strictly limited in this application. In addition, although a structure of the damping member 28 is described in this implementation, the damping member 28 may have a plurality of implementation structures. Any damping member 28 that can be configured to provide damping force for the first large gear connecting rod 25 is within the protection scope of this application.

It may be understood that the damping member 28 may apply the damping force to the first large gear connecting rod 25, the second large gear connecting rod 26, the first small gear connecting rod 27a, and the second small gear connecting rod 27b, so that the first large gear connecting rod 25, the second large gear connecting rod 26, the first small gear connecting rod 27a, and the second small gear connecting rod 27b are limited to a specific degree. In other words, when the first large gear connecting rod 25, the second large gear connecting rod 26, the first small gear connecting rod 27a, and the second small gear connecting rod 27b are not subject to large external force, the damping member 28 can cause the first large gear connecting rod 25, the second large gear connecting rod 26, the first small gear connecting rod 27a, and the second small gear connecting rod 27b to maintain a preset relative position relationship, that is, the folding mechanism 100 can stay at a preset angle, and the folding mechanism 100 can maintain the unfolded state or the folded state, to improve user experience of the folding mechanism 100 and the electronic device 1000.

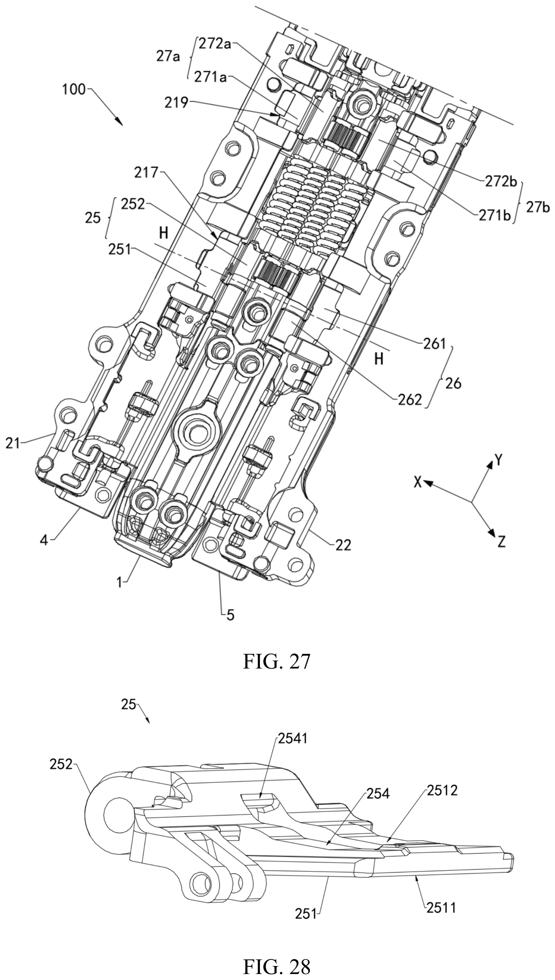

FIG. 27 is a diagram 4 of a partial structure of the folding mechanism 100 shown in FIG. 7 according to an implementation.

As shown in FIG. 27, the sliding end 251 of the first large gear connecting rod 25 is slidably connected to the first fastening bracket 21. For example, at least a part of the sliding end 251 of the first large gear connecting rod 25 may be located in the second sliding space 217 of the first fastening bracket 21. The sliding end 251 of the first large gear connecting rod 25 may slide in the second sliding space 217 of the first fastening bracket 21.

In addition, the sliding end 261 of the second large gear connecting rod 26 is slidably connected to the second fastening bracket 22. It may be understood that, for a connection relationship between the sliding end 261 of the second large gear connecting rod 26 and the second fastening bracket 22, refer to a connection relationship between the sliding end 251 of the first large gear connecting rod 25 and the first fastening bracket 21. Details are not described herein again.

As shown in FIG. 27, the sliding end 271a of the first small gear connecting rod 27a is slidably connected to the first fastening bracket 21. For example, at least a part of the sliding end 271a of the first small gear connecting rod 27a may be located in the third sliding space 218 of the first fastening bracket 21. The sliding end 271a of the first small gear connecting rod 27a may slide in the third sliding space 218 of the first fastening bracket 21.

In addition, the sliding end 271b of the second small gear connecting rod 27b is slidably connected to the second fastening bracket 22. It may be understood that, for a connection relationship between the sliding end 271b of the second small gear connecting rod 27b and the second fastening bracket 22, refer to a connection relationship between the sliding end 271a of the first small gear connecting rod 27a and the first fastening bracket 21. Details are not described herein again.

It may be understood that the first fastening bracket 21 is fastened to the first housing 300 (refer to FIG. 6), and the second fastening bracket 22 is fastened to the second housing 400 (refer to FIG. 6). Therefore, the first housing 300 may be connected to the second housing 400 via the first fastening bracket 21, the first large gear connecting rod 25, the second large gear connecting rod 26, the first small gear connecting rod 27a, the second small gear connecting rod 27b, and the second fastening bracket 22. In this way, when the electronic device 1000 switches from the unfolded state to the folded state, the first housing 300 and the second housing 400 approach each other, the first housing 300 can drive, via the first large gear connecting rod 25 and the first small gear connecting rod 27a, the first fastening bracket 21 to rotate relative to the main shaft 1, and the second housing 400 can drive, via the second large gear connecting rod 26 and the second small gear connecting rod 27b, the second fastening bracket 22 to rotate relative to the main shaft 1. When the electronic device 1000 switches from the folded state to the unfolded state, the first housing 300 and the second housing 400 are unfolded relative to each other, the first housing 300 can drive, via the first large gear connecting rod 25 and the first small gear connecting rod 27a, the first fastening bracket 21 to rotate relative to the main shaft 1, and the second housing 400 can drive, via the second large gear connecting rod 26 and the second small gear connecting rod 27b, the second fastening bracket 22 to rotate relative to the main shaft 1.

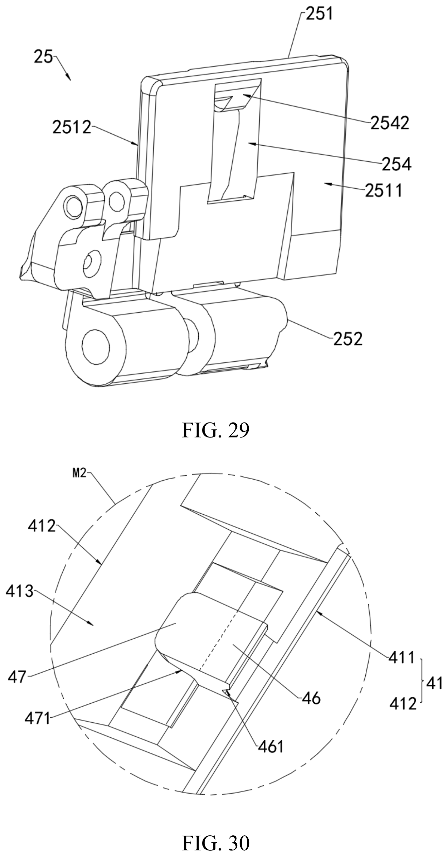

FIG. 28 is a diagram of a structure of the first large gear connecting rod 25 shown in FIG. 11 according to another implementation. FIG. 29 is a diagram of a structure of the first large gear connecting rod 25 shown in FIG. 28 from another angle.

As shown in FIG. 28 and FIG. 29, for example, a first through hole 254 is disposed on the first large gear connecting rod 25. The first through hole 254 penetrates from a top surface 2511 of the sliding end 251 of the first large gear connecting rod 25 to a bottom surface 2512 of the sliding end 251 of the first large gear connecting rod 25.

For example, a hole wall of the first through hole 254 includes a first fitting surface 2541. The first fitting surface 2541 is a part of the hole wall that is of the first through hole 254 and that is close to the rotating end 252 of the first large gear connecting rod 25.

For example, the first fitting surface 2541 is inclined to the rotating end 252 of the first large gear connecting rod 25, that is, the first fitting surface 2541 is disposed at an obtuse angle with the bottom surface 2512 of the sliding end 251 of the first large gear connecting rod 25.

FIG. 30 is an enlarged diagram of the first support plate 4 shown in FIG. 8 at M3 according to an implementation.

As shown in FIG. 30, the first support plate 4 further includes a first abutting block 46. The first abutting block 46 protrudes from the first fastening surface 413. The first abutting block 46 includes a second fitting surface 461. The second fitting surface 461 is a part of a surface that is of an outer surface of the first abutting block 46 and that faces the right side surface 411 of the first support plate body 41.

For example, the second fitting surface 461 is disposed closer to the right side surface 411 of the first support plate body 41 than to the left side surface 412 of the first support plate body 41.

For example, the second fitting surface 461 is disposed to be inclined to the direction of the right side surface 411 of the first support plate body 41. In this case, the second fitting surface 461 is disposed at an acute angle with the first fastening surface 413.

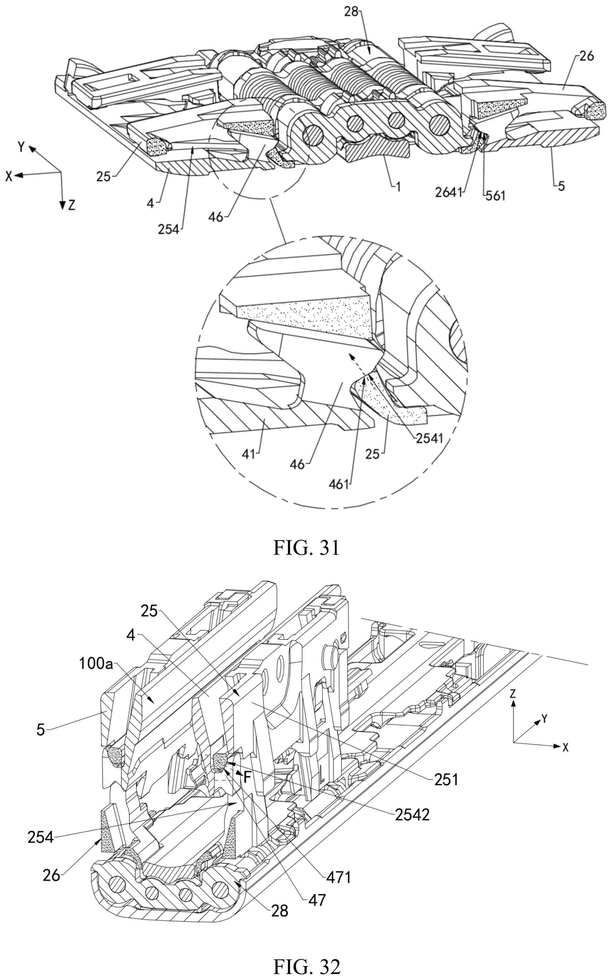

FIG. 31 is a partially sectional view of the folding mechanism 100 shown in FIG. 27 at an H-H line according to an implementation.

Refer to FIG. 31. With reference to FIG. 28 to FIG. 30, when the electronic device 1000 is in the unfolded state, at least a part of the first abutting block 46 of the first support plate 4 is located in the first through hole 254 of the first large gear connecting rod 25, and the first fitting surface 2541 of the first large gear connecting rod 25 abuts against the second fitting surface 461 of the first support plate 4. The first fitting surface 2541 of the first large gear connecting rod 25 and the second fitting surface 461 of the first support plate 4 form a lap joint surface.

For example, the first fitting surface 2541 of the first large gear connecting rod 25 may be in interference fit with the second fitting surface 461 of the first support plate 4, so that the first support plate 4 generates acting force in a movement direction. In this way, because there is a magnitude of interference set between the first fitting surface 2541 of the first large gear connecting rod 25 and the second fitting surface 461 of the first support plate 4, acting force can be generated between the first fitting surface 2541 of the first large gear connecting rod 25 and the second fitting surface 461 of the first support plate 4. Therefore, the acting force is used to control the angle between the first support plate 4 and the main shaft 1, that is, control the form of the first support plate 4 in the unfolded state of the electronic device 1000. For example, the acting force between the first fitting surface 2541 of the first large gear connecting rod 25 and the second fitting surface 461 of the first support plate 4 may cause the angle between the first support plate 4 and the main shaft 1 to be equal to 180° as much as possible, to ensure that the flexible display 200 is completely unfolded. In this way, the flexible display 200 has good appearance consistency, to meet user experience.

It may be understood that, for different folding mechanisms 100, angles between first support plates 4 and main shafts 1 deviate from 180° by different amplitudes when the electronic device 1000 is in the unfolded state. In this case, the angle between the first support plate 4 and the main shaft 1 can be adjusted to different degrees by adjusting the magnitude of the interference between the first fitting surface 2541 of the first large gear connecting rod 25 and the second fitting surface 461 of the first support plate 4 to different degrees, to better control the form of the first support plate 4 in the unfolded state of the electronic device 1000. For example, for some folding mechanisms 100, when the electronic device 1000 is in the unfolded state, the angle between the first support plate 4 and the main shaft 1 is 190° that deviates from 180° by a large amplitude. In this case, the magnitude of the interference between the first fitting surface 2541 of the first large gear connecting rod 25 and the second fitting surface 461 of the first support plate 4 can be greatly increased, to adjust the angle between the first support plate 4 and the main shaft 1 to a large degree in the unfolded state of the electronic device 1000, so that the angle between the first support plate 4 and the main shaft 1 can be 180°. For some folding mechanisms 100, when the electronic device 1000 is in the unfolded state, the angle between the first support plate 4 and the main shaft 1 is 185° that deviates from 180° by a small amplitude. In this case, the magnitude of the interference between the first fitting surface 2541 of the first large gear connecting rod 25 and the second fitting surface 461 of the first support plate 4 can be slightly increased, to slightly adjust the angle between the first support plate 4 and the main shaft 1, so that the angle between the first support plate 4 and the main shaft 1 can be 180°.

In this implementation, when the electronic device 1000 is in the unfolded state, the damping member 28 applies the damping force to the first large gear connecting rod 25. In this way, the first large gear connecting rod 25 is not likely to rotate relative to the main shaft 1 under the action of the damping force. In other words, the first large gear connecting rod 25 can be well in a locked state. In this case, stability of interference fit between the first fitting surface 2541 of the first large gear connecting rod 25 and the second fitting surface 461 of the first support plate 4 is good.

In this implementation, the second fitting surface 461 is disposed close to the right side surface 411 of the first support plate body 41. In this case, the second fitting surface 461 is disposed close to the main shaft 1. The lap joint surface formed by the first fitting surface 2541 of the first large gear connecting rod 25 and the second fitting surface 461 of the first support plate 4 is disposed closer to the main shaft 1. In this way, the angle between the first support plate 4 and the main shaft 1 can be adjusted to a large degree by slightly increasing the magnitude of the interference between the first fitting surface 2541 of the first large gear connecting rod 25 and the second fitting surface 461 of the first support plate 4, so that the form between the first support plate 4 and the main shaft 1 in the unfolded state of the electronic device 1000 can be better controlled, and precision of adjusting the angle between the first support plate 4 and the main shaft 1 in the unfolded state of the electronic device 1000 is also high. For example, when the lap joint surface formed by the first fitting surface 2541 of the first large gear connecting rod 25 and the second fitting surface 461 of the first support plate 4 is far away from the main shaft 1, the magnitude of the interference between the first fitting surface 2541 of the first large gear connecting rod 25 and the second fitting surface 461 of the first support plate 4 needs to be set to 0.5 millimeters, so that the angle between the first support plate 4 and the main shaft 1 is 180°. When the lap joint surface formed by the first fitting surface 2541 of the first large gear connecting rod 25 and the second fitting surface 461 of the first support plate 4 is close to the main shaft 1, the magnitude of the interference between the first fitting surface 2541 of the first large gear connecting rod 25 and the second fitting surface 461 of the first support plate 4 is set to 0.2 millimeters, so that the angle between the first support plate 4 and the main shaft 1 is 180°.

In this implementation, the first fitting surface 2541 is disposed to be inclined to the rotating end 252 of the first large gear connecting rod 25, and the second fitting surface 461 is inclined to the direction of the right side surface 411 of the first support plate body 41, so that the lap joint surface formed by the first fitting surface 2541 of the first large gear connecting rod 25 and the second fitting surface 461 of the first support plate 4 is disposed in an inclined manner. In this way, when the first fitting surface 2541 of the first large gear connecting rod 25 is in interference fit with the second fitting surface 461 of the first support plate 4 when the electronic device 1000 is in the unfolded state, the acting force between the first fitting surface 2541 of the first large gear connecting rod 25 and the second fitting surface 461 of the first support plate 4 has greater acting force in a movement direction (for example, component force in a Z-axis direction is greater), so that the angle between the first support plate 4 and the main shaft 1 in the unfolded state of the electronic device 1000 can be better controlled, and the form between the first support plate 4 and the main shaft 1 in the unfolded state of the electronic device 1000 can be better controlled.

It may be understood that, as shown in FIG. 31, for a fitting relationship between the second support plate 5 and the second large gear connecting rod 26, refer to a fitting relationship between the first support plate 4 and the first large gear connecting rod 25 (for example, the second large gear connecting rod 26 has a second fitting surface 2641, the second support plate 5 has a second fitting surface 561, and the second fitting surface 2641 of the second large gear connecting rod 26 is in interference fit with the second fitting surface 561 of the second support plate 5 when the electronic device 1000 is in the unfolded state, so that the second support plate 5 generates acting force in a movement direction). Details are not described herein again. In this way, the second support plate 5 fits with the second large gear connecting rod 26, so that when the electronic device 1000 is in the unfolded state, the angle between the second support plate 5 and the main shaft 1 is equal to 180° as much as possible, and the angle between the second support plate 5 and the main shaft 1 can also be equal to 180° as much as possible, to ensure, to a large degree, that the flexible display 200 is completely unfolded. In this way, the flexible display 200 has better appearance consistency, to meet user experience.

It may be understood that, with reference to the related accompanying drawings, the foregoing specifically describes the fitting relationship between the first large gear connecting rod 25 and the first support plate 4 and the fitting relationship between the second support plate 5 and the second large gear connecting rod 26 in the unfolded state of the electronic device 1000. In another implementation, when the electronic device 1000 is in the unfolded state, for a fitting relationship between the first small gear connecting rod 27a and the first support plate 4, also refer to the fitting relationship between the first large gear connecting rod 25 and the first support plate 4. For a fitting relationship between the second small gear connecting rod 27b and the second support plate 5, also refer to the fitting relationship between the second large gear connecting rod 26 and the second support plate 5. Details are not described herein again.

It may be understood that, for a fitting relationship between the first connecting arm 20a in another position of the folding mechanism 100 and the first support plate 4 in the unfolded state of the electronic device 1000, also refer to the fitting relationship between the first large gear connecting rod 25 and the first support plate 4. In addition, for a fitting relationship between the second connecting arm 20b in another position of the folding mechanism 100 and the second support plate 5, also refer to the fitting relationship between the second large gear connecting rod 26 and the second support plate 5. Details are not described herein again.

It may be understood that, in another implementation, for a connection relationship between the first large gear connecting rod 25 and the first support plate 4, also refer to a connection relationship between the first rotating member 23 and the first support plate 4. Specifically, the sliding end 251 of the first large gear connecting rod 25 is slidably connected to the first support plate 4, and the sliding end 251 of the first large gear connecting rod 25 rotates relative to the first support plate 4. In addition, for a connection relationship between the first small gear connecting rod 27a and the first support plate 4, also refer to the connection relationship between the first rotating member 23 and the first support plate 4. Specifically, the sliding end 271a of the first small gear connecting rod 27a is slidably connected to the first support plate 4, and the sliding end 271a of the first small gear connecting rod 27a rotates relative to the first support plate 4.

As shown in FIG. 29, for example, the hole wall of the first through hole 254 includes a third fitting surface 2542. The third fitting surface 2542 is a part of the hole wall that is of the first through hole 254 and that is away from the rotating end 252 of the first large gear connecting rod 25.

For example, the third fitting surface 2542 is disposed at an acute angle with the top surface 2511 of the sliding end 251 of the first large gear connecting rod 25.

As shown in FIG. 30, the first support plate 4 further includes a second abutting block 47. The second abutting block 47 protrudes from the first fastening surface 413. The second abutting block 47 includes a fourth fitting surface 471. The fourth fitting surface 471 is a part of a surface that is of an outer surface of the second abutting block 47 and that faces the left side surface 412 of the first support plate body 41. In FIG. 30, the second abutting block 47 and the first abutting block 46 are schematically distinguished by using a dashed line.

For example, the fourth fitting surface 471 is disposed closer to the left side surface 412 of the first support plate body 41 than to the right side surface 411 of the first support plate body 41.

For example, the fourth fitting surface 471 is disposed to be inclined to the direction of the left side surface 412 of the first support plate body 41. In this case, the fourth fitting surface 471 is disposed at an acute angle with the first fastening surface 413.

For example, the second abutting block 47 is connected to the first abutting block 46, that is, the second abutting block 47 and the first abutting block 46 may form an integrated structure. In this way, the first abutting block 46 and the second abutting block 47 are arranged more compactly on the first support plate body 41, and space utilization is high. In addition, a forming process of the first abutting block 46 and the second abutting block 47 is also simple.

FIG. 32 is a partially sectional view of the electronic device 1000 shown in FIG. 3 at an I-I line according to an implementation.

As shown in FIG. 32, when the electronic device 1000 is in the folded state, at least a part of the second abutting block 47 of the first support plate 4 is located in the first through hole 254 of the sliding end 251 of the first large gear connecting rod 25, and the third fitting surface 2542 of the first large gear connecting rod 25 abuts against the fourth fitting surface 471 of the first support plate 4. The third fitting surface 2542 of the first large gear connecting rod 25 and the fourth fitting surface 471 of the first support plate 4 form a lap joint surface.

For example, the third fitting surface 2542 of the first large gear connecting rod 25 may be in interference fit with the fourth fitting surface 471 of the first support plate 4. In this way, because there is a magnitude of interference set between the third fitting surface 2542 of the first large gear connecting rod 25 and the fourth fitting surface 471 of the first support plate 4, acting force F can be generated between the third fitting surface 2542 of the first large gear connecting rod 25 and the fourth fitting surface 471 of the first support plate 4. Component force of the acting force F in a positive direction of the X-axis may cause the first support plate 4 to be opened in the positive direction of the X-axis. In this case, the screen-accommodating space 100a enclosed by the first support plate 4, the main shaft 1, and the second support plate 5 can be increased. This helps improve the reliability of the flexible display 200. It may be understood that FIG. 32 schematically provides a direction of an implementation of the acting force F by using a dashed line with an arrow.

It may be understood that, when the electronic device 1000 is in the folded state, an opening angle of the first support plate 4 can be adjusted to different degrees by adjusting the magnitude of the interference between the third fitting surface 2542 of the first large gear connecting rod 25 and the fourth fitting surface 471 of the first support plate 4 to different degrees, to better control a size of the screen-accommodating space 100a.

It may be understood that, when the electronic device 1000 is in the folded state, the damping member 28 applies the damping force to the first large gear connecting rod 25. In this way, the first large gear connecting rod 25 is not likely to rotate relative to the main shaft 1 under the action of the damping force. In other words, the first large gear connecting rod 25 can be well in the locked state. In this case, stability of interference fit between the third fitting surface 2542 of the first large gear connecting rod 25 and the fourth fitting surface 471 of the first support plate 4 is good.

In this implementation, the third fitting surface 2542 is disposed at the acute angle with the top surface 2511 of the sliding end 251 of the first large gear connecting rod 25, and the fourth fitting surface 471 is disposed at the acute angle with the first fastening surface 413, so that the lap joint surface formed by the third fitting surface 2542 of the first large gear connecting rod 25 and the fourth fitting surface 471 of the first support plate 4 is disposed in an inclined manner. In this way, when the third fitting surface 2542 of the first large gear connecting rod 25 is in interference fit with the fourth fitting surface 471 of the first support plate 4 when the electronic device 1000 is in the folded state, the acting force between the third fitting surface 2542 of the first large gear connecting rod 25 and the fourth fitting surface 471 of the first support plate 4 has the greater component force in the X-axis direction, so that the opening angle of the first support plate 4 can be larger in the positive direction of the X-axis. In this case, the screen-accommodating space 100a enclosed by the first support plate 4, the main shaft 1, and the second support plate 5 can be even larger. This better helps improve the reliability of the flexible display 200.

With reference to the related accompanying drawings, the foregoing specifically describes the fitting relationship between the first large gear connecting rod 25 and the first support plate 4 in the folded state of the electronic device 1000, and for a fitting relationship between the second large gear connecting rod 26 and the second support plate 5 in the folded state of the electronic device 1000, refer to the fitting relationship between the first large gear connecting rod 25 and the first support plate 4 in the folded state of the electronic device 1000. Details are not described herein again. In this way, when the electronic device 1000 is in the folded state, the first support plate 4 is opened in the positive direction of the X-axis, and the second support plate 5 is opened in a negative direction of the X-axis. In this case, the screen-accommodating space 100a enclosed by the first support plate 4, the main shaft 1, and the second support plate 5 may be even larger. This better helps improve the reliability of the flexible display 200.

It may be understood that, with reference to the related accompanying drawings, the foregoing specifically describes the fitting relationship between the first large gear connecting rod 25 and the first support plate 4 and the fitting relationship between the second support plate 5 and the second large gear connecting rod 26 in the folded state of the electronic device 1000. In another implementation, when the electronic device 1000 is in the folded state, for the fitting relationship between the first small gear connecting rod 27a and the first support plate 4, also refer to the fitting relationship between the first large gear connecting rod 25 and the first support plate 4. For the fitting relationship between the second small gear connecting rod 27b and the second support plate 5, also refer to the fitting relationship between the second large gear connecting rod 26 and the second support plate 5. Details are not described herein again.

It may be understood that, for the fitting relationship between the first connecting arm 20a in the another position of the folding mechanism 100 and the first support plate 4 in the folded state of the electronic device 1000, also refer to the fitting relationship between the first large gear connecting rod 25 and the first support plate 4. In addition, for a fitting relationship between the second connecting arm 20b in another position of the folding mechanism 100 and the second support plate 5, also refer to the fitting relationship between the second large gear connecting rod 26 and the second support plate 5. Details are not described herein again.

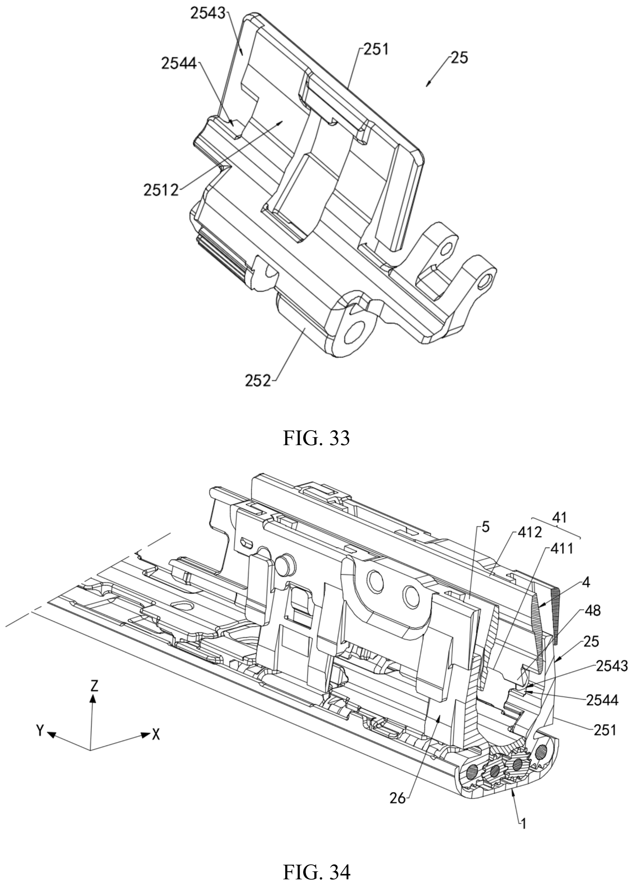

FIG. 33 is a diagram of a structure of the first large gear connecting rod 25 shown in FIG. 11 according to still another implementation.

As shown in FIG. 33, for example, a first accommodation groove 2543 is disposed at the sliding end 251 of the first large gear connecting rod 25. An opening of the first accommodation groove 2543 is formed on the bottom surface 2512 of the sliding end 251 of the first large gear connecting rod 25.

The first large gear connecting rod 25 includes a bearing surface 2544. The bearing surface 2544 faces away from the rotating end 252 of the first large gear connecting rod 25. The bearing surface 2544 may be a part of a groove wall that is in the first accommodation groove 2543 and that faces away from the rotating end 252 of the first large gear connecting rod 25.

FIG. 34 is a partially sectional view of the electronic device 1000 shown in FIG. 3 at a J-J line according to an implementation.

As shown in FIG. 34, the first support plate 4 has a second extension block 48. The second extension block 48 protrudes from the right side surface 411 of the first support plate body 41.

As shown in FIG. 33 and FIG. 34, when the electronic device 1000 is in the folded state, the second extension block 48 of the first support plate 4 is disposed opposite to the bearing surface 2544 of the first large gear connecting rod 25. In this way, when the electronic device 1000 in the folded state falls, the bearing surface 2544 of the first large gear connecting rod 25 can support the second extension block 48 of the first support plate 4, to prevent the first support plate 4 from falling in a direction close to the main shaft 1, and further prevent the first support plate 4 from driving the flexible display 200 to fall in a falling process. This ensures that the electronic device 1000 has good reliability.

For example, the second extension block 48 of the first support plate 4 is not in contact with the bearing surface 2544 of the first large gear connecting rod 25. In this way, in a process of unfolding or folding the folding mechanism 100, the second extension block 48 of the first support plate 4 and the first large gear connecting rod 25 do not easily interfere with each other.

It may be understood that, for the fitting relationship between the second support plate 5 and the second large gear connecting rod 26, also refer to the fitting relationship between the first support plate 4 and the first large gear connecting rod 25. Details are not described herein again. In this way, the second support plate 5 fits with the second large gear connecting rod 26, to prevent the second support plate 5 from falling in the direction close to the main shaft 1, and further prevent the second support plate 5 from driving the flexible display 200 to fall in a falling process. This ensures that the electronic device 1000 has good reliability.

It may be understood that, with reference to the related accompanying drawings, the foregoing specifically describes the fitting relationship between the first large gear connecting rod 25 and the first support plate 4 and the fitting relationship between the second support plate 5 and the second large gear connecting rod 26 in the folded state of the electronic device 1000. In another implementation, when the electronic device 1000 is in the folded state, for the fitting relationship between the first small gear connecting rod 27a and the first support plate 4, also refer to the fitting relationship between the first large gear connecting rod 25 and the first support plate 4. For the fitting relationship between the second small gear connecting rod 27b and the second support plate 5, also refer to the fitting relationship between the second large gear connecting rod 26 and the second support plate 5. Details are not described herein again.

It should be noted that embodiments in this application and features in embodiments may be combined with each other without a conflict, and any combination of features in different embodiments also falls within the protection scope of this application. In other words, the foregoing described plurality of embodiments may be further combined based on an actual requirement.

It should be noted that all the foregoing accompanying drawings are examples of this application, and do not represent an actual size of a product. In addition, a dimension proportional relationship between parts in the accompanying drawings is not intended to limit an actual product in this application. The foregoing descriptions are merely some embodiments and implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A folding mechanism (100), comprising a main shaft (1), a first fastening bracket (21), a second fastening bracket (22), a first rotating member (23), a second rotating member (24), a first support plate (4), a second support plate (5), and a first connecting arm (20a), wherein the main shaft (1) is located between the first fastening bracket (21) and the second fastening bracket (22);
the first rotating member (23) movably connects the main shaft (1) to the first fastening bracket (21), and the second rotating member (24) movably connects the main shaft (1) to the second fastening bracket (22);
the first support plate (4) movably connects the first fastening bracket (21) to the first rotating member (23), the second support plate (5) movably connects the second fastening bracket (22) to the second rotating member (24), and when the folding mechanism (100) is in an unfolded state, the first support plate (4) and the second support plate (5) jointly form a support surface (100b), or when the folding mechanism (100) is in a folded state, the first support plate (4) and the second support plate (5) are disposed opposite to each other, and enclose a screen-accommodating space (100a) with the main shaft (1); and
the first connecting arm (20a) movably connects the first fastening bracket (21) to the main shaft (1), the first connecting arm (20a) has a first fitting surface (2541), the first support plate (4) has a second fitting surface (461), and when the folding mechanism (100) is in the unfolded state, the first fitting surface (2541) of the first connecting arm (20a) is in interference fit with the second fitting surface (461) of the first support plate (4).

2. The folding mechanism (100) according to claim 1, wherein the first connecting arm (20a) has a third fitting surface (2542), and the first support plate (4) has a fourth fitting surface (471); and
when the folding mechanism (100) is in the folded state, the third fitting surface (2542) of the first connecting arm (20a) is in interference fit with the fourth fitting surface (471) of the first support plate (4).

3. The folding mechanism (100) according to claim 2, wherein the first support plate (4) comprises a first support plate body (41), a first abutting block (46), and a second abutting block (47);
the first support plate body (41) comprises a first fastening surface (413), and a first side surface (411) and a second side surface (412) that are disposed back to back, the first fastening surface (413) is connected between the second side surface (412) and the first side surface (411), the first fastening surface (413) faces the first fastening bracket (21), and the first side surface (411) faces the main shaft (1);
the first abutting block (46) protrudes from the first fastening surface (413), and the second fitting surface (461) is a part of a surface that is of the first abutting block (46) and that faces the first side surface (411); and
the second abutting block (47) protrudes from the first fastening surface (413), and the fourth fitting surface (471) is a part of a surface that is of the second abutting block (47) and that faces the second side surface (412).

4. The folding mechanism (100) according to claim 3, wherein the first abutting block (46) and the second abutting block (47) are of an integrated structure.

5. The folding mechanism (100) according to claim 3 or 4, wherein the second fitting surface (461) is disposed closer to the first side surface (411) than to the second side surface (412).

6. The folding mechanism (100) according to any one of claims 3 to 5, wherein the second fitting surface (461) is disposed at an acute angle with the first fastening surface (413), and/or the fourth fitting surface (471) is disposed at an acute angle with the first fastening surface (413).

7. The folding mechanism (100) according to any one of claims 3 to 6, wherein a first through hole (254) is disposed on the first connecting arm (20a), and when the folding mechanism (100) is in the unfolded state, at least a part of the first abutting block (46) is located in the first through hole (254); and
the first fitting surface (2541) of the first connecting arm (20a) is a part of a hole wall of the first through hole (254).

8. The folding mechanism (100) according to any one of claims 1 to 7, wherein the first connecting arm (20a) further has a bearing surface (2544); and
when the folding mechanism (100) is in the folded state, the bearing surface (2544) is disposed opposite to a part of the first support plate (4).

9. The folding mechanism (100) according to any one of claims 1 to 8, wherein the folding mechanism (100) comprises a second connecting arm (20b), and the second connecting arm (20b) movably connects the second fastening bracket (21) to the main shaft (1); and
the second connecting arm (20b) has a second fitting surface (2641), the second support plate (5) has a second fitting surface (561), and when the folding mechanism (100) is in the unfolded state, the second fitting surface (2641) of the second connecting arm (20b) is in interference fit with the second fitting surface (561) of the second support plate (5).

10. The folding mechanism (100) according to claim 9, wherein the folding mechanism (100) comprises a damping member (28), the damping member (28) is disposed on the main shaft (1), and the damping member (28) is configured to apply damping force to the first connecting arm (20a) and the second connecting arm (24).

11. The folding mechanism (100) according to claim 10, wherein the first connecting arm (20a) comprises a first large gear connecting rod (25), the first large gear connecting rod (25) comprises a sliding end (251) and a rotating end (252), the sliding end (251) of the first large gear connecting rod (25) is slidably connected to the first fastening bracket (21), and the rotating end (252) of the first large gear connecting rod (25) is rotatably connected to the main shaft (1);
the second connecting arm (24) comprises a second large gear connecting rod (26), the second large gear connecting rod (26) comprises a sliding end (261) and a rotating end (262), the sliding end (261) of the second large gear connecting rod (26) is slidably connected to the second fastening bracket (22), and the rotating end (262) of the second large gear connecting rod (26) is rotatably connected to the main shaft (1);
the folding mechanism (100) further comprises a first synchronization gear (281), a first clamping member (283), and a first elastic member (288);
the first synchronization gear (281) is rotatably connected to the main shaft (1), and the rotating end (252) of the first large gear connecting rod (25) is meshed with the rotating end (262) of the second large gear connecting rod (26) via the first synchronization gear (281);
the first clamping member (283) and the first elastic member (288) are located on the main shaft (1), the first clamping member (283) is located between the first elastic member (288) and the first synchronization gear (281), and the first clamping member (283) forms a clamping structure with both the rotating end (252) of the first large gear connecting rod (25) and the rotating end (262) of the second large gear connecting rod (26); and
the first elastic member (288) is in a compressed state, and elastic force generated by the first elastic member (288) causes the first clamping member (283) to abut against the rotating end (252) of the first large gear connecting rod (25) and the rotating end (262) of the second large gear connecting rod (26).

12. The folding mechanism (100) according to claim 11, wherein the folding mechanism (100) further comprises a first small gear connecting rod (27a), a second small gear connecting rod (27b), a second synchronization gear (282), a third clamping member (285), and a fourth clamping member (286);
a sliding end (271a) of the first small gear connecting rod (27a) is slidably connected to the first fastening bracket (21), a rotating end (272a) of the first small gear connecting rod (27a) is rotatably connected to the main shaft (1), a sliding end (271b) of the second small gear connecting rod (27b) is slidably connected to the second fastening bracket (22), and a rotating end (272b) of the second small gear connecting rod (27b) is rotatably connected to the main shaft (1);
the second synchronization gear (282) is located on a side that is of the first elastic member (288) and that is away from the first clamping member (283), and is rotatably connected to the main shaft (1), and the rotating end (272a) of the first small gear connecting rod (27a) is meshed with the rotating end (272b) of the second small gear connecting rod (27b) via the second synchronization gear (282);
the third clamping member (285) and the fourth clamping member (286) are located on the main shaft (1), the third clamping member (285) is located between the first elastic member (288) and the second synchronization gear (282), the fourth clamping member (286) is located on a side that is of the second synchronization gear (282) and that is away from the third clamping member (285), and the third clamping member (285) and the fourth clamping member (286) form a clamping structure with both the rotating end (272a) of the first small gear connecting rod (27a) and the rotating end (272b) of the second small gear connecting rod (27b); and
the first elastic member (288) is in the compressed state, and the elastic force generated by the first elastic member (288) causes the third clamping member (285) to abut against the rotating end (272a) of the first small gear connecting rod (27a) and the rotating end (272b) of the second small gear connecting rod (27b).

13. The folding mechanism (100) according to any one of claims 1 to 12, wherein the first rotating member (23) comprises a rotating end (231) and a sliding end (232), the rotating end (231) of the first rotating member (23) is rotatably connected to the main shaft (1), and the sliding end (232) of the first rotating member (23) is slidably connected to the first fastening bracket (21);
the first support plate (4) is slidably connected to the sliding end (232) of the first rotating member (23) and rotates relative to the sliding end (232) of the first rotating member (23); and
the first rotating member (23) comprises a first abutting surface (2324), the first support plate (4) further comprises a second abutting surface (415), and when the folding mechanism (100) is in the unfolded state, the first abutting surface (2324) of the first rotating member (23) is in interference fit with the second abutting surface (415) of the first support plate (4).

14. The folding mechanism (100) according to claim 13, wherein the first support plate (4) comprises the first support plate body (41) and a first movable block (42);
the first support plate body (41) comprises the first fastening surface (413), and the second side surface (412) and the first side surface (411) that are disposed back to back, the first fastening surface (413) is connected between the second side surface (412) and the first side surface (411), the first fastening surface (413) faces the first fastening bracket (21), and the first side surface (411) faces the main shaft (1);
the first movable block (42) protrudes from the first fastening surface (413) of the first support plate body (41), and the first movable block (42) has a first inclined hole (414);
the folding mechanism (100) comprises a pin shaft (44), two ends of the pin shaft (44) are fastened to the sliding end (232) of the first rotating member (23), a middle part of the pin shaft (44) passes through the first inclined hole (414), and the middle part of the pin shaft (44) slides in the first inclined hole (414) of the first support plate (4) and rotates relative to the first inclined hole (414); and
the second abutting surface (415) is a part of a surface that is of an outer ring surface of the first movable block (42) and that faces the first side surface (411).

15. The folding mechanism (100) according to claim 14, wherein the second abutting surface (415) is disposed closer to the first side surface (411) than to the second side surface (412).

16. The folding mechanism (100) according to claim 14 or 15, wherein the second abutting surface (415) is disposed at an acute angle with the first fastening surface (413).

17. The folding mechanism (100) according to any one of claims 1 to 16, wherein the main shaft (1) comprises a first contact surface (1131), and the first support plate (4) comprises a second contact surface (4111); and
when the folding mechanism (100) is in the unfolded state, the first contact surface (1131) abuts against the second contact surface (4111).

18. The folding mechanism (100) according to claim 17, wherein the first contact surface (1131) is a part of a side surface (113) of the main shaft (1), and the second contact surface (4111) is a part of the first side surface (411) of the first support plate (4).

19. The folding mechanism (100) according to any one of claims 1 to 18, wherein the first support plate (4) comprises the first support plate body (41) and a first extension block (45);
the first support plate body (41) comprises the second side surface (412) and the first side surface (411) that are disposed back to back, the first side surface (411) faces the main shaft (1), and the first extension block (45) protrudes from the first side surface (411); and
when the folding mechanism (100) is in the unfolded state, the first extension block (45) is disposed opposite to a part of the main shaft (1).

20. An electronic device (1000), comprising a first housing (300), a second housing (400), a flexible display (200), and the folding mechanism (100) according to any one of claims 1 to 19, wherein the first fastening bracket (21) is fastened to the first housing (300), and the second fastening bracket (22) is fastened to the second housing (400);
the flexible display (200) comprises a first display region (201), a second display region (202), and a third display region (203) that are sequentially connected to each other, the first display region (201) is fastened to the first housing (300), and the third display region (203) is fastened to the second housing (400); and
when the folding mechanism (100) is in the unfolded state, the first support plate (4) and the second support plate (5) support the second display region (202); or
when the folding mechanism (100) is in the folded state, the second display region (202) is located in the screen-accommodating space (100a).
